# EUROPEAN PATENT SPECIFICATION

(11) **EP 4 428 192 B1**
(45) Date of publication and mention of the grant of the patent: **29.10.2025**
(21) Application number: 24161553.3
(22) Date of filing: 05.03.2024
(51) Int. Cl.: C08L 63/00, H05K 1/16, C08G 63/91, C08J 5/18, H05K 1/00, C08K 3/08, C08G 63/06, C08G 63/685, H01F 17/00, H05K 3/46

(54) **RESIN COMPOSITION**
HARZZUSAMMENSETZUNG
COMPOSITION DE RÉSINE

(30) Priority: 06.03.2023 JP 2023033729
(43) Date of publication of application: 11.09.2024
(73) Proprietor: AJINOMOTO CO., INC., Chuo-ku Tokyo 104-8315 (JP)
(72) Inventor: SAITO, Mizuki, Kanagawa, 210-0801 (JP); TANAKA, Takayuki, Kanagawa, 210-0801 (JP); HOMMA, Tatsuya, Kanagawa, 210-0801 (JP)
(74) Representative: Mewburn Ellis LLP

(56) References cited:
- EP-A1- 3 879 542
- WO-A1-2022/202939
- JP-A- 2020 087 939
- JP-A- 2021 152 108
- JP-A- 2022 120 452

## Description

### BACKGROUND OF THE INVENTION

### 1. Field of the Invention

The present invention relates to a resin composition, as well as a resin sheet, a circuit board, and an inductor component, these being formed by using the resin composition.

### 2. Description of the Related Art

A built-in inductor board having an inductor built in a circuit board such as a printed wiring board is generally formed using a magnetic layer, which is a cured product of a resin composition containing magnetic powder in order to increase an inductance.

For example, in Japanese Patent Application Laid-open No. 2022-120452, it is described that an inductor is formed by using a resin sheet.
EP 3879542 A1 relates to a resin composition, as well as a magnetic sheet, a circuit substrate, and an inductor substrate thereof.
JP 2020 087939 A relates to a magnetic paste, an inductor element obtained by using the magnetic paste, a circuit board, and a method for manufacturing the inductor element. WO 2022/202939 A1 relates to a curable resin composition, and more particularly to a curable resin composition that can be used as a filling material for filling through holes such as through holes and recesses in printed wiring boards.
JP 2021 152108 A relates to a resin composition containing a magnetic powder, as well as a cured product, an electronic component, a neodymium magnet-containing motor thereof.

### SUMMARY OF THE INVENTION

When producing the resin sheet having a resin composition layer that includes a resin composition, from the viewpoint of making the sheet, the resin composition has been generally required to include a polymer compound having a weight-average molecular weight of about 30000.

However, when the polymer compound is included in the resin composition, mechanical strength of the resin composition layer in the resin sheet can be decreased in some cases.

The present invention was made in light of these circumstances; thus, an object of the present invention is to provide a resin composition capable of producing a cured product having a high specific magnetic permeability, a low loss factor, and excellent mechanical strength, and to provide a resin sheet, a circuit board, and an inductor board, all being obtained by using the resin composition.

The inventor of the present invention carried out an extensive investigation to achieve the above-mentioned object, and as a result, it was found that by using a resin composition that includes a combination of a resin having a weight-average molecular weight of 600 or more, an epoxy resin, an amine type dispersant, a solvent, and a magnetic powder, a cured product of a resin composition layer exhibited a high specific magnetic permeability, a low loss factor, and excellent mechanical strength. The present invention was completed on the basis of this finding.

Aspects of the invention are set out in the appended claims.

### Advantageous Effects of Invention

According to the present invention, provided are: a resin sheet capable of producing a cured product having an enhanced specific magnetic permeability, a lowered loss factor, and excellent mechanical strength; and a circuit board and an inductor component, both being obtained by using the resin sheet.

### BRIEF DESCRIPTION OF THE DRAWINGS

Fig. 1 is a schematic sectional view illustrating a core substrate before forming a through hole in a circuit board producing method according to a first embodiment;
Fig. 2 is a schematic sectional view illustrating the core substrate formed with the through hole in the circuit board producing method according to the first embodiment;
Fig. 3 is a schematic sectional view illustrating the core substrate having a plated layer formed in the through hole in the circuit board producing method according to the first embodiment;
Fig. 4 is a schematic sectional view illustrating the state of laminating the core substrate with a resin sheet in the circuit board producing method according to the first embodiment;
Fig. 5 is a schematic sectional view illustrating the laminated state of the core substrate with the resin sheet in the circuit board producing method according to the first embodiment;
Fig. 6 is a schematic sectional view to explain step (2) in the circuit board producing method according to the first embodiment;
Fig. 7 is a schematic sectional view to explain step (3) in the circuit board producing method according to the first embodiment;
Fig. 8 is a schematic sectional view to explain step (5) in the production method of the circuit board according to the first embodiment;
Fig. 9 is a schematic sectional view to explain the step (5) in the production method of the circuit board according to the first embodiment;
Fig. 10 is a schematic sectional view to explain step (A) in a circuit board producing method according to a second embodiment;
Fig. 11 is a schematic sectional view to explain the step (A) in the circuit board producing method according to the second embodiment;
Fig. 12 is a schematic sectional view to explain step (B) in the circuit board producing method according to the second embodiment;
Fig. 13 is a schematic sectional view to explain step (D) in the circuit board producing method according to the second embodiment;
Fig. 14 is a schematic plan view observed from one side along the thickness direction of an inductor component that includes the circuit board obtained by the circuit board producing method according to the second embodiment;
Fig. 15 is a schematic view illustrating a cut end face of the inductor component including the circuit board obtained by the circuit board producing method according to the second embodiment; the inductor component being cut at the place indicated by the II-II one dot chain line; and
Fig. 16 is a schematic plan view to explain a composition of a first conductive layer in the inductor component that includes the circuit board obtained by the circuit board producing method according to the second embodiment.

### DETAILED DESCRIPTION OF THE PREFERRED EMBODIMENTS

Hereinafter, with referring to the drawings, embodiments of the present invention will be explained. In these drawings, the shape, size, and arrangement of the composition elements are roughly illustrated so as to merely help to understand the present invention. The present invention is not limited by the embodiments described below; and thus, each of the composition elements may be changed as appropriate. In the following drawings to be used for explanation, the same composition elements are tagged with the same symbols, and there are cases that the overlapped explanation thereof is omitted. In addition, the compositions relating to the embodiments of the present invention are not necessarily produced or used in accordance with the arrangements illustrated in the drawings.

### Resin Composition

The resin composition according to the present invention includes (A) a resin having a weight-average molecular weight of 600 or more, (B) an epoxy resin (excluding those falling under the component (A)), (C) an amine type dispersant, and (D) a magnetic powder. By using the resin composition as described above, it is possible to obtain a cured product having a high specific magnetic permeability, a low loss factor, and excellent mechanical strength.

The resin composition may further include optional components such as (E) a solvent, (F) a curing agent, and (G) other additives, as needed.

Hereinafter, each component included in the resin composition will be described in detail. In the present invention, the content of each component in the resin composition is a value relative to 100% by mass of non-volatile components in the resin composition unless otherwise specifically mentioned, in which the non-volatile components mean non-volatile components excluding the solvent in the resin composition.

### (A) Resin Having Weight-average Molecular Weight of 600 or More

The resin composition contains (A) a resin having a weight-average molecular weight of 600 or more as the component (A). By including (A) the resin having a weight-average molecular weight of 600 or more in the resin composition, it is possible to enhance mechanical strength of a cured product of the resin composition. The component (A) may be used singly, or as a combination of two or more kinds of the resins.

From the viewpoint of enhancing the mechanical strength, the weight-average molecular weight of the component (A) is 600 or more, preferably 700 or more, and more preferably 800 or more. The upper limit thereof is preferably 100000 or less, more preferably 50000 or less, and still more preferably 40000 or less, 30000 or less, 20000 or less, 10000 or less, 9000 or less, 8000 or less, 7500 or less, or 7000 or less. Note that the weight-average molecular weight of the resin is the weight-average molecular weight in terms of polystyrene measured with a gel permeation chromatography (GPC) method.

From the viewpoint to clearly obtain the advantageous effects of the present invention, it is preferable that the component (A) includes any of (A-1) a resin oligomer having a weight average molecular weight of 600 or more and less than 8000 and (A-2) a resin having a weight-average molecular weight of 8000 or more. Thus, the component (A) may include only (A-1) the resin oligomer having a weight-average molecular weight of 600 or more and less than 8000, or only (A-2) the resin having a weight-average molecular weight of 8000 or more, or a combination of (A-1) the resin oligomer having a weight-average molecular weight of 600 or more and less than 8000 and (A-2) the resin having a weight-average molecular weight of 8000 or more. It is preferable that the component (A) includes (A-1) the resin oligomer having a weight-average molecular weight of 600 or more and less than 8000.

From the viewpoint to clearly obtain the advantageous effects of the present invention, it is preferable that the weight-average molecular weight of the component (A-1) is 600 or more, preferably 700 or more, and more preferably 800 or more. The upper limit thereof is preferably less than 8000, preferably 7500 or less, and more preferably 7000 or less.

From the viewpoint to clearly obtain the advantageous effects of the present invention, it is preferable that the weight-average molecular weight of the component (A-2) is 8000 or more, preferably 9000 or more, and more preferably 10000 or more. The upper limit thereof is preferably 100000 or less, more preferably 50000 or less, and still more preferably 40000 or less.

As for the component (A-1), the resin oligomer having a weight-average molecular weight of 600 or more and less than 8000 may be used. As for the component like this, any of a thermosetting resin oligomer having a thermosetting functional group such as an epoxy group and a thermoplastic resin oligomer is preferable, and a thermosetting resin oligomer is more preferable. Illustrative examples of the thermosetting resin oligomer include an epoxy group-containing oligomer and a phenol resin oligomer. The term "epoxy group-containing oligomer" means an oligomer having an epoxy group. In particular, the epoxy group-containing oligomer is preferable as the component (A-1). The component (A-1) may be used singly, or as a combination of two or more kinds of these oligomers.

It is preferable that the epoxy group-containing oligomer contains two or more epoxy groups in one molecule. In addition, the epoxy group-containing oligomer having an aromatic structure is preferable. When two or more epoxy group-containing oligomers are used, it is more preferable that at least one of them has an aromatic structure. The aromatic structure is the chemical structure that is generally defined as an aromatic compound, including a polycyclic aromatic compound and an aromatic heterocycle. The ratio of the epoxy group-containing oligomer having two or more epoxy groups in one molecule relative to 100% by mass of the non-volatile components in the epoxy group-containing oligomer is preferably 50% by mass or more, more preferably 60% by mass or more, and especially preferably 70% by mass or more.

As for the epoxy group-containing oligomer, a bisphenol type epoxy group-containing oligomer is preferable, and a bisphenol A type epoxy group-containing oligomer, a bisphenol F type epoxy group-containing oligomer, and a bisphenol AF type epoxy group-containing oligomer are preferable, and any of the bisphenol A type epoxy group-containing oligomer and the bisphenol F type epoxy group-containing oligomer is more preferable. Illustrative examples of the epoxy group-containing oligomer include specifically "jER1001" (bisphenol A type epoxy group-containing oligomer), "jER4005P" (bisphenol F type epoxy group-containing oligomer), "jER1004AF (polyether type epoxy group-containing oligomer produced from bisphenol A), "jER4005P" (bisphenol F type epoxy group-containing oligomer), and "jER1010" (bisphenol A type epoxy resin), all of which are manufactured by Mitsubishi Chemical Corp.; and "EXA-4850-150" (modified bisphenol type epoxy resin) manufactured by DIC Corp. These may be used singly or as a combination of two or more of them.

The epoxy equivalent of the epoxy group-containing oligomer is preferably in the range of 50 g/eq. to 5000 g/eq., more preferably in the range of 50 g/eq. to 3000 g/eq., still more preferably in the range of 80 g/eq. to 2000 g/eq., and far still more preferably in the range of 110 g/eq. to 1000 g/eq. Within this range, the crosslinking density of the cured product is sufficient, so that a magnetic layer having a low surface roughness may be obtained. The epoxy equivalent, which is a mass of the resin including one equivalent of the epoxy group, may be measured with a method in accordance with JIS K7236.

As for the phenol resin oligomer, a commercially available product may be used. Illustrative examples of the commercially available phenol resin oligomer include "S-1P" and "S-1P" manufactured by Maruzen Petrochemical Co., Ltd.

The content of the component (A-1) relative to 100% by mass of the non-volatile components in the resin composition is, from the viewpoint to clearly obtain the advantageous effects of the present invention, preferably 0.1% by mass or more, more preferably 0.2% by mass or more, still more preferably 0.3% by mass or more, and preferably 5% by mass or less, more preferably 3% by mass or less, and still more preferably 1% by mass or less.

As for the component (A-2), the resin having a weight-average molecular weight of 8000 or more may be used. As for the component like this, any of a thermosetting resin and a thermoplastic resin is preferable, and a thermoplastic resin is more preferable. Illustrative examples of the thermoplastic resin include a phenoxy resin, a polyvinyl acetal resin, a polyolefin resin, a polyimide resin, a polybutadiene resin, a polyamide imide resin, a polyether imide resin, a polysulfone resin, a polyether sulfone resin, a polyphenylene ether resin, a polyether ether ketone resin, and a polyester resin. Among these, a phenoxy resin is preferable. The component (A-2) may be used singly, or as a combination of two or more kinds of these resins.

Illustrative examples of the phenoxy resin include those having one or more skeletons selected from the group consisting of a bisphenol A skeleton, a bisphenol F skeleton, a bisphenol S skeleton, a bisphenol acetophenone skeleton, a novolac skeleton, a biphenyl skeleton, a fluorene skeleton, a dicyclopentadiene skeleton, a norbornene skeleton, a naphthalene skeleton, an anthracene skeleton, an adamantane skeleton, a terpene skeleton, and a trimethylcyclohexane skeleton. The phenoxy resin may be terminated with any functional group, such as a phenolic hydroxyl group or an epoxy group. Specific examples of the phenoxy resin include "1256" and "4250" (both phenoxy resins containing a bisphenol A skeleton) manufactured by Mitsubishi Chemical Corp.; "YX8100" (phenoxy resin containing a bisphenol S skeleton) manufactured by Mitsubishi Chemical Corp.; "YX6954" (phenoxy resin containing a bisphenol acetophenone skeleton) manufactured by Mitsubishi Chemical Corp.; "FX280" and "FX293" manufactured by Nippon Steel Chemical & Material Co., Ltd.; and "YL7500BH30", "YX6954BH30", "YX7553", "YX7553BH30", "YL7769BH30", "YL6794", "YL7213", "YL7290", "YL7482", and "YL7891BH30", all being manufactured by Mitsubishi Chemical Corp.

Illustrative examples of the polyvinyl acetal resin include a polyvinylformal resin and a polyvinyl butyral resin; here, the polyvinyl butyral resin is preferable. Specific examples of the polyvinyl acetal resin include "Denka Butyral 4000-2", "Denka Butyral 5000-A", "Denka Butyral 6000-C", and "Denka Butyral 6000-EP", all of them being manufactured by Denka Company Limited; and the S-LEC BH series, the BX series (e.g., BX-5Z), the KS series (e.g., KS-1), the BL series, and the BM series, all of them being manufactured by Sekisui Chemical Co., Ltd.

Illustrative examples of the polyolefin resin include a low-density polyethylene, a ultra-low-density polyethylene, a high-density polyethylene, as well as ethylene copolymers such as an ethylene-vinyl acetate copolymer, an ethylene-ethyl acrylate copolymer, and an ethylene-methyl acrylate copolymer; and polyolefin polymers such as a polypropylene and an ethylene-propylene block copolymer.

Specific examples of the polyimide resin include "SLK-6100" manufactured by Shin-Etsu Chemical Co., Ltd.; and "Rikacoat SN20" and "Rikacoat PN20" manufactured by New Japan Chemical Co., Ltd. Specific examples of the polyimide resin also include a linear polyimide obtained by reacting a bifunctional hydroxyl group-terminated polybutadiene, a diisocyanate compound, and a tetrabasic acid anhydride (polyimide described in Japanese Patent Application Laid-open No. 2006-37083), and modified polyimides such as the polyimides containing a polysiloxane skeleton (polyimides described in Japanese Patent Application Laid-open No. 2002-12667 and Japanese Patent Application Laid-open No. 2000-319386).

Illustrative examples of the polybutadiene resin include a resin containing a hydrogenated polybutadiene skeleton, a polybutadiene resin containing a hydroxy group, a polybutadiene resin containing a phenolic hydroxy group, a polybutadiene resin containing a carboxy group, a polybutadiene resin containing an acid anhydride group, a polybutadiene resin containing an epoxy group, a polybutadiene resin containing an isocyanate group, a polybutadiene resin containing a urethane group, and a polyphenylene ether-polybutadiene resin.

Specific examples of the polyamide imide resin include "Vyromax HR11NN" and "Vyromax HR16NN", both being manufactured by Toyobo Co., Ltd. Specific examples of the polyamide imide resin also include modified polyamide imides such as "KS9100" and "KS9300" (polyamide imide containing a polysiloxane skeleton) manufactured by Resonac Co., Ltd.

Specific examples of the polyethersulfone resin include "PES5003P" manufactured by Sumitomo Chemical Co., Ltd.

Specific examples of the polysulfone resin include polysulfone "P1700" and "P3500", both being manufactured by Solvay Advanced Polymers, Inc.

Specific examples of the polyphenylene ether resin include "NORYL SA90" manufactured by SABIC. Specific examples of the polyether imide resin include "Ultem" manufactured by GE.

Illustrative examples of the polycarbonate resin include a hydroxy group-containing carbonate resin, a phenolic hydroxy group-containing carbonate resin, a carboxy group-containing carbonate resin, an acid anhydride group-containing carbonate resin, an isocyanate group-containing carbonate resin, and a urethane group-containing carbonate resin. Specific examples of the polycarbonate resin include "FPC0220" manufactured by Mitsubishi Gas Chemical Co. Ltd., "T6002" and "T6001" (polycarbonate diol) manufactured by Asahi Kasei; and "C-1090", "C-2090", and "C-3090" (polycarbonate diol) manufactured by Kuraray Co., Ltd. Specific examples of the polyether ether ketone resin include "Sumiploy **K"** manufactured by Sumitomo Chemical Co., Ltd.

Illustrative examples of the polyester resin include a polyethylene terephthalate resin, a polyethylene naphthalate resin, a polybutylene terephthalate resin, a polybutylene naphthalate resin, a polytrimethylene terephthalate resin, a polytrimethylene naphthalate resin, and a polycyclohexanedimethyl terephthalate resin.

The content of the component (A-2) relative to 100% by mass of the non-volatile components in the resin composition is preferably 0.5% by mass or more, more preferably 1% by mass or more, or 1.5% by mass or more, and from the viewpoint to clearly obtain the advantageous effects of the present invention, this is preferably 5% by mass or less, more preferably 3% by mass or less, still more preferably 2% by mass or less, and especially preferably 0% by mass.

From the viewpoint to clearly obtain the advantageous effects of the present invention, the lower the content of the component (A-2) is, the more preferable. Relative to 100% by mass of the non-volatile components in the resin composition, when the content of the component (A-1) is represented by A1 and the content of the component (A-2) is represented by A2, from the viewpoint to clearly obtain the advantageous effects of the present invention, A2/(A1 + A2) is preferably 0 or more, more preferably 0.2 or more, still more preferably 0.4 or more, or 0.6 or more, and preferably 0.7 or less.

The content of the component (A) (total content of the component (A-1) and the component (A-2)) relative to 100% by mass of the non-volatile components in the resin composition is, from the viewpoint to clearly obtain the advantageous effects of the present invention, preferably 0.1% by mass or more, more preferably 0.2% by mass or more, still more preferably 0.3% by mass or more, and preferably 5% by mass or less, more preferably 3% by mass or less, and still more preferably 2% by mass or less.

### (B) Epoxy Resin

The resin composition includes (B) an epoxy resin as the component (B). The epoxy resin (B) as the component (B) does not include those that fall under the component (A) described above. By including the epoxy resin (B) in the resin composition, it is possible to obtain a cured product of the resin composition having excellent mechanical strength. The epoxy resin (B) may be used singly or as a combination of two or more kinds.

Illustrative examples of the epoxy resin (B) include: a bisphenol A type epoxy resin; a bisphenol F type epoxy resin; a bisphenol S type epoxy resin; a bisphenol AF type epoxy resin; a dicyclopentadiene type epoxy resin; a trisphenol type epoxy resin; a phenol novolac type epoxy resin; a tert-butyl-catechol type epoxy resin; an epoxy resin having a condensed cyclic structure such as a naphthol novolac type epoxy resin, a naphthalene type epoxy resin, a naphthol type epoxy resin, and an anthracene type epoxy resin; a glycidyl amine type epoxy resin; a glycidyl ester type epoxy resin; a cresol novolac type epoxy resin; a biphenyl type epoxy resin; a linear aliphatic epoxy resin; an epoxy resin having a butadiene structure; an alicyclic epoxy resin; a heterocyclic epoxy resin; an epoxy resin having a spiro ring; a cyclohexane dimethanol type epoxy resin; a trimethylol type epoxy resin; a tetraphenylethane type epoxy resin; and a cyclic aliphatic diglycidyl ether type epoxy resin. These epoxy resins may be used singly or as a combination of two or more of those described above. The epoxy resin (B) is preferably one or more kinds selected from a bisphenol A type epoxy resin and a bisphenol F type epoxy resin, and more preferably to include a bisphenol A type epoxy resin and a bisphenol F type epoxy resin.

It is preferable that the epoxy resin (B) includes an epoxy resin having two or more epoxy groups in one molecule. In addition, it is preferable that the epoxy resin (B) has an aromatic structure. When two or more of the epoxy resins are used, it is more preferable that at least one of them has an aromatic structure. The aromatic structure is the chemical structure that is generally defined as an aromatic compound, including a polycyclic aromatic compound and an aromatic heterocycle. The ratio of the epoxy resin having two or more epoxy groups in one molecule relative to 100% by mass of the non-volatile components in the epoxy resin is preferably 50% by mass or more, and more preferably 60% by mass or more, and especially preferably 70% by mass or more.

In the epoxy resin, there are an epoxy resin that is in the state of liquid at 25°C (hereinafter, this is sometimes called "liquid epoxy resin") and an epoxy resin that is in the state of solid at 25°C (hereinafter, this is sometimes called "solid epoxy resin"). The resin composition may include, as the epoxy resin (B), only the liquid epoxy resin, or only the solid epoxy resin, or the liquid epoxy resin and the solid epoxy resin as a combination; but, from the viewpoint to decrease a viscosity of the resin composition, it is preferable to include only the liquid epoxy resin.

The liquid epoxy resin is preferably a glycirol type epoxy resin, a bisphenol A type epoxy resin, a bisphenol F type epoxy resin, a bisphenol AF type epoxy resin, a naphthalene type epoxy resin, a glycidyl ester type epoxy resin, a glycidyl amine type epoxy resin, a phenol novolac type epoxy resin, an alicyclic epoxy resin having an ester skeleton, a cyclohexane dimethanol type epoxy resin, an alicyclic diglycidyl ether type epoxy resin, an alicyclic glycidyl ether type epoxy resin, an alicyclic glycidyl ether type epoxy resin, and an epoxy resin having a butadiene structure. Among these, a bisphenol A type epoxy resin and a bisphenol F type epoxy resin are more preferable. Specific examples of the liquid epoxy resin include "HP4032", "HP4032D", and "HP4032SS" (naphthalene type epoxy resins), which are all manufactured by DIC Corp.; "828US" and "jER828EL" (bisphenol A type epoxy resins), "jER807" (bisphenol F type epoxy resin), and "jER152" (phenol novolac type epoxy resin), which are all manufactured by Mitsubishi Chemical Corp.; "630" and "630LSD", which are both manufactured by Mitsubishi Chemical Corp.; "ED-523T" (glycirol type epoxy resin (ADEKA glycirol)), "EP-3980S" (glycidyl amine type epoxy resin), and "EP-4088S" (dicyclopentadiene type epoxy resin), which are all manufactured by ADEKA Corp.; "ZX1059" (mixture of bisphenol A type epoxy resin and bisphenol F type epoxy resin), "EX-201" (alicyclic glycidyl ether type epoxy resin), "ZX1658" and "ZX1658GS (alicyclic diglycidyl ether type epoxy resins), which are all manufactured by Nippon Steel Chemical & Material Co., Ltd.; "EX-721" (glycidyl ester type epoxy resin) manufactured by Nagase ChemteX Corp.; and "Celloxide 2021P" (alicyclic epoxy resin having an ester skeleton) and "PB-3600" (epoxy resin having a butadiene structure), which are both manufactured by Daicel Corp. These may be used singly or as a combination of two or more of them.

The solid epoxy resin is preferably a naphthalene type 4-functional epoxy resin, a cresol novolac type epoxy resin, a dicyclopentadiene type epoxy resin, a trisphenol type epoxy resin, a naphthol type epoxy resin, a biphenyl type epoxy resin, a naphthylene ether type epoxy resin, an anthracene type epoxy resin, a bisphenol A type epoxy resin, and a tetraphenylethane type epoxy resin. Specific examples of the solid epoxy resin include: "HP4032H" (naphthalene type epoxy resin), "HP-4700" and "HP-4710" (both are naphthalene type 4-functional epoxy resins); "N-690" (cresol novolac type epoxy resin), "N-695" (cresol novolac type epoxy resin), "HP-7200", "HP-7200HH", and "HP-7200H" (all are dicyclopentadiene type epoxy resins), "EXA-7311", "EXA-7311-G3", "EXA-7311-G4", "EXA-7311-G4S", and "HP6000" (all are naphthylene ether type epoxy resins), all of these resins being manufactured by DIC Corp.; "EPPN-502H" (trisphenol type epoxy resin), "NC7000L" (naphthol novolac type epoxy resin), and "NC3000H", "NC3000", "NC3000L", and "NC3100" (all are biphenyl type epoxy resins), all of these resins being manufactured by Nippon Kayaku Co., Ltd.; "ESN475V" (naphthalene type epoxy resin) and "ESN485" (naphthol novolac type epoxy resin), both being manufactured by Nippon Steel Chemical & Material Co., Ltd.; "YX4000H" and "YL6121" (both are biphenyl type epoxy resins), "YX4000HK" (bixylenol type epoxy resin), and "YX8800" (anthracene type epoxy resin), all of them being manufactured by Mitsubishi Chemical Corp.; "PG-100" and "CG-500", both being manufactured by Osaka Gas Chemicals Co., Ltd.; and "YL7760" (bisphenol AF type epoxy resin), "YL7800" (fluorene type epoxy resin), "jER1010" (solid bisphenol A type epoxy resin), and "jER1031S" (tetraphenylethane type epoxy resin), all of them being manufactured by Mitsubishi Chemical Corp. These may be used singly or as a combination of two or more of them.

When the liquid epoxy resin and the solid epoxy resin are used in combination as the epoxy resin (B), the quantity ratio (in mass ratio) thereof (liquid epoxy resin:solid epoxy resin) is preferably in the range of 1:0.1 to 1:4. By setting the quantity ratio of the liquid epoxy resin to the solid epoxy resin in the range described above, it is possible to obtain a cured product expressing advantageous effects including a sufficient rupture strength. From the viewpoint of the advantageous effects, the quantity ratio (in mass ratio) of the liquid epoxy resin to the solid epoxy resin (liquid epoxy resin:solid epoxy resin) is more preferably in the range of 1:0.3 to 1:3.5, still more preferably in the range of 1:0.6 to 1:3, and especially preferably in the range of 1:0.8 to 1:2.5.

The epoxy equivalent of the epoxy resin (B) is preferably in the range of 50 g/eq. to 5000 g/eq., more preferably in the range of 50 g/eq. to 3000 g/eq., still more preferably in the range of 80 g/eq. to 2000 g/eq., and far still more preferably in the range of 110 g/eq. to 1000 g/eq. Within this range, the crosslinking density of the cured product is sufficient, so that a magnetic layer having a low surface roughness may be obtained. The epoxy equivalent, which is a mass of the resin including one equivalent of the epoxy group, may be measured with a method in accordance with JIS K7236.

The weight-average molecular weight (Mw) of the epoxy resin (B) is preferably less than 600, more preferably 500 or less, and still more preferably 400 or less. The lower limit thereof is not particularly restricted; this is preferably 100 or more, more preferably 150 or more, and still more preferably 200 or more.

From the viewpoint to obtain the magnetic layer having excellent mechanical strength, the content of the epoxy resin (B) (% by mass) relative to 100% by mass of the non-volatile components in the resin composition is preferably 0.1% by mass or more, more preferably 0.3% by mass or more, still more preferably 0.5% by mass or more, and especially preferably 1% by mass or more. Although the upper limit of the content of the epoxy resin is not particularly restricted as long as the advantageous effects of the present invention are expressed, this is preferably 5% by mass or less, more preferably 3% by mass or less, and still more preferably 2% by mass or less.

The content of the epoxy resin (B) (% by volume) relative to 100% by volume of the non-volatile components in the resin composition is preferably 1% by volume or more, more preferably 3% by volume or more, and still more preferably 5% by volume or more. Although the upper limit thereof is not particularly restricted as long as the advantageous effects of the present invention are expressed, this is preferably 25% by volume or less, more preferably 20% by volume or less, and still more preferably 15% by volume or less.

Relative to 100% by mass of the non-volatile components in the resin composition, when the content of the component (A) (total content of the component (A-1) and the component (A-2)) is represented by Am and the content of the epoxy resin (B) is represented by Bm, from the viewpoint to clearly obtain the advantageous effects of the present invention, Am/(Am + Bm) is preferably 0.1 or more, more preferably 0.15 or more, and still more preferably 0.2 or more, and preferably 0.8 or less, more preferably 0.4 or less, and still more preferably 0.3 or less.

### (C) Amine Type Dispersant

The resin composition includes (C) an amine type dispersant as the component (C). The amine type dispersant (C) as the component (C) does not include those that fall under the component (A) and the component (B) described above. As mentioned before, from the viewpoint of making a sheet, when a polymer compound is included in the resin composition, the mechanical strength of the cured product of the resin composition decreases. In the present invention, by including the component (C) in the resin composition in combination with the component (A), it is possible to improve the mechanical strength as well while improving the specific magnetic permeability compared to the resin composition that does not include the component (A) and the component (C) (that is, a resin composition having the same composition as that of the resin composition, except that a polymer compound having a higher molecular weight than that of the component (A) is included in place of the component (A) and the component (C)). The amine type dispersant (C) may be used singly or as a combination of two or more kinds thereof.

The amine type dispersant (C) of the present invention refers to a dispersant having an amine skeleton, and is preferably a polyamine skeleton. The amine value of the component (C) is preferably 1 mg KOH/g or more, more preferably 5 mg KOH/g or more, and still more preferably 10 mg KOH/g or more, and preferably 45 mg KOH/g or less, more preferably 40 mg KOH/g or less, and still more preferably 35 mg KOH/g or less. The amine value may be measured by the neutralization titration method. Specifically, it may be measured by the following method.

### Measurement of Amine Value of Amine Type Dispersant

15 g of sample (in terms of solid content) is weighed into a 200-mL conical beaker, followed by adding 75 mL of toluene thereto. Then, 50 mL of ethanol is added, and the resulting solution is heated as needed to dissolve the sample homogeneously to obtain a solution.

To this solution, 10 drops of a thymol blue reagent are added and mixed homogeneously, and then, the mixture is titrated with 0.5 mol/L hydrochloric acid while shaking the solution. Titration is terminated when the solution exhibited a light red color, and the amine value is calculated using the following formula. Amine value (mg KOH/g) = (A × f × 56.106 × 0.5)/sample mass (g)
A: Volume of 0.5 mol/L hydrochloric acid (mL)
f: Factor (titer) of 0.5 mol/L hydrochloric acid

The component (C) may have an acid functional group such as a carboxyl group. The acid value of the component (C) is preferably 1 mg KOH/g or more, more preferably 3 mg KOH/g or more, and still more preferably 5 mg KOH/g or more, and preferably 30 mg KOH/g or less, more preferably 28 mg KOH/g or less, and still more preferably 25 mg KOH/g or less. The acid value may be measured by the neutralization titration method, specifically according to JIS K 0070.

One embodiment of the amine type dispersant (C) may be the use of a dispersant containing a polyester skeleton derived from a polyester; specifically, a dispersant containing a polyester skeleton derived from a polyester or an amine skeleton derived from an amine, and preferably a polyamine skeleton. The component (A) has a smaller weight-average molecular weight than that of a conventionally used polymer compound; thus, this is more compatible with the polyester skeleton. In addition, because the polymer compound has a long molecular length, the distance between magnetic powders in the resin composition increases, resulting in a decrease in the specific magnetic permeability. However, because the component (A) used in the present invention has a shorter molecular length than the polymer compound does, the distance between magnetic powders in the resin composition decreases. As a result, it is presumed that the magnetic moment increases, thereby leading to increase in the specific magnetic permeability. **The** nitrogen atom in the amine skeleton adsorbs a magnetic powder, thereby resulting in the aspect in which the amine skeleton encapsulates as a shell the magnetic powder in a core. As a result, it is presumed to realize the improvement in the mechanical strength of the cured product of the resin composition.

**The** polyester skeleton is derived from a polyester, in which the polyester skeleton is preferably represented by the general formula (1). 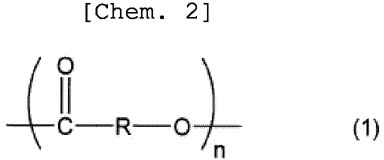 (In the general formula (1), each R independently represents a divalent hydrocarbon group having 2 to 10 carbon atoms optionally having a substituent, and n represents an integer of 2 to 1000.)

R in the general formula (1) represents a divalent hydrocarbon group having 2 to 10 carbon atoms. The carbon number in the hydrocarbon group is 2 or more, preferably 3 or more, and more preferably 4 or more. The upper limit of the carbon number is 10 or less, preferably 8 or less, and more preferably 6 or less. The hydrocarbon group may be linear, branched, or cyclic; a linear hydrocarbon group and a branched hydrocarbon group are preferable. Examples of the hydrocarbon group include an aliphatic hydrocarbon group and an aromatic hydrocarbon group; an aliphatic hydrocarbon group is preferable. The hydrocarbon group may be any of saturated and unsaturated hydrocarbon groups; a saturated hydrocarbon group is preferable. Illustrative examples of the hydrocarbon group include an alkylene group, an alkenylene group, an alkynylene group, and an arylene group. Among them, an alkylene group is especially preferable as the hydrocarbon group.

Illustrative examples of the alkylene group include an ethylene group, a propylene group, a butylene group, a pentylene group, a hexylene group, a heptylene group, an octylene group, a nonylene group, and a decylene group. Illustrative examples of the alkenylene group include an ethenylene group, a propenylene group, a butenylene group, a pentenylene group, a hexenylene group, a heptenylene group, an octenylene group, a nonenylene group, and a decenylene group. Illustrative examples of the alkynylene group include an ethynylene group, a pyropynylene group, a butynylene group, a pentynylene group, a hexynylene group, a heptynylene group, an octynylene group, a noninylene group, and a decynylene group. Illustrative examples of the arylene group include a phenylene group and a naphtylene group. Among these, a butylene group and a pentylene group are preferable as R.

The divalent hydrocarbon group represented by R in the general formula (1) may or may not have a substituent. There is no particular restriction in the substituent. Illustrative examples thereof include a halogen atom, -OH, an -O-C₁₋₆ alkyl group, a -N(C₁₋₁₀ alkyl group)₂, a C₁₋₁₀ alkyl group, a C₆₋₁₀ aryl group, -NH₂, -CN, a -C(O)O-C₁₋₁₀ alkyl group, -COOH, -C(O)H, and -NO₂. Here, the term "C_{p-q}" (p and q each represent a positive integer, satisfying p < q) indicates that the number of the carbon atom in the organic group described immediately after this term is p to q. For example, the expression "C₁₋₁₀ alkyl group" indicates an alkyl group having 1 to 10 carbon atoms. These substituents may be bonded together to form a ring; here, the ring structure includes a spiro ring and a fused ring.

The substituent described above may further have a substituent (sometimes this is referred to as "secondary substituent"). The secondary substituent may be the same as those listed above, unless otherwise specifically noted.

n in the general formula (1) represents an integer of 2 to 1000. n is 2 or more, preferably 5 or more, and more preferably 10 or more. The upper limit thereof is 1000 or less, preferably 500 or less, more preferably 100 or less, or 50 or less.

The amine skeleton is a skeleton derived from an amine. Illustrative examples of the amine include a polyallylamine and a polyvinylamine. Among these, a polyallylamine is preferable.

The component (C) may contain an optional skeleton in addition to the amine skeleton and a polyester skeleton. Examples of the optional skeleton include a polyester skeleton in which R in the general formula (1) is a divalent hydrocarbon group having 1, or 11 or more carbon atoms (n is the same as that in the formula (1)). The terminal of this polyester skeleton is not particularly restricted.

Illustrative examples of the terminal of the component (C) include a carboxylic acid residue, which will be described later, a hydroxy group, and a hydrogen atom.

The component (C) may be produced, for example, by reacting a polyamine with a polyester. Examples of the polyamine include a polyallylamine and a polyvinylamine; a polyallylamine is preferable.

The polyamine may be obtained by polymerizing monomeric amines in the presence of a polymerization initiator and/or a chain transfer catalyst. For example, the polyallylamine may be obtained by polymerizing an allylamine in the presence of a polymerization initiator and/or a chain transfer catalyst.

There is no particular restriction in the polymerization initiator. Illustrative examples thereof include ketone peroxides such as methyl ethyl ketone; diacyl peroxides such as benzoyl peroxide; peroxydicarbonates such as diisopropyl peroxydicarbonate; peroxy ketals such as 1,1-bis(t-butylperoxy)cyclohexane; hydroperoxides such as t-butylhydroperoxide; peroxyesters such as t-butylperoxypivalate; and azobisisobutyronitrile, hydrogen peroxide, and a ferrous salt. In addition, polymerization initiators described in Japanese Examined Patent Publication No. H02-14364 may also be used. These may be used singly or two or more of those listed above may be used.

There is no particular restriction in the chain transfer catalyst. Illustrative examples thereof include: alkyl mercaptans such as lauryl mercaptan; thiocarboxylic acids such as mercaptoacetic acid, 2-mercaptopropionic acid, and 3-mercaptopropionic acid; and thiocarboxylate esters such as butyl thioglycolate and 2-ethylhexyl thioglycolate. These may be used singly or two or more of those listed above may be used.

The weight-average molecular weight of the polyamine is preferably in the range of 150 to 100000, and more preferably in the range of 600 to 20000. When the weight-average molecular weight of the polyamine is 150 or more, adsorption to the particle is improved, thereby increasing the particle dispersibility; and when the weight-average molecular weight of the polyamine is 100000 or less, aggregation among the particles is suppressed, thereby increasing the particle dispersibility. Polyamines having any weight-average molecular weight may be produced using the method described in Japanese Examined Patent Publication No. H02-14364.

Commercially available polyamine may be used. Illustrative examples of the commercially available polyamine include "PAA-01", "PAA-03", "PAA-05", "PAA-08", "PAA-15", "PAA-15C", and "PAA-25", all being manufactured by Nittobo Medical Co., Ltd.

The polyester may be produced, for example, by reacting a lactone represented by the general formula (2) with a carboxylic acid. 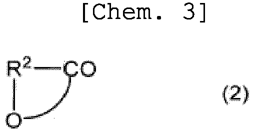 (In the general formula (2), R² is the same as R in the general formula (1).)

Illustrative examples of the lactone represented by the general formula (2) include ε-caprolactone, β-propiolactone, γ-butyrolactone, δ-valerolactone, β-methyl-δ-valerolactone, 4-methylcaprolactone, and 2-methylcaprolactone.

The carboxylic acid that may be used are those that function as an initiator for the ring-opening polymerization of the lactone represented by the general formula (2). Illustrative examples of the carboxylic acid like this include hydroxycarboxylic acids such as ricinol acid, ricinoleic acid, 9- and 10-hydroxystearic acid, a castor oil fatty acid, a hydrogenated castor oil fatty acid, lactic acid, 12-hydroxystearic acid, and glycolic acid; and dodecanoic acid, and stearic acid. Among these, a hydroxycarboxylic acid is preferable.

The reaction temperature is preferably in the range of 120 to 220°C, and more preferably in the range of 160 to 210°C. The reaction time is preferably in the range of 0.5 to 72 hours. When the reaction is carried out under a nitrogen stream, the polyester having a high degree of polymerization may be obtained.

In the reaction, a polymerization catalyst or a polymerization initiator may be used as needed, with a view to control the reaction.

Illustrative examples of the polymerization catalyst include quaternary ammonium salts such as tetramethylammonium chloride, tetrabutylammonium chloride, tetramethylammonium bromide, tetrabutylammonium bromide tetramethylammonium iodide, tetrabutylammonium iodide, benzyltrimethylammonium chloride, benzyltrimethylammonium bromide, and benzyltrimethylammonium iodide; quaternary phosphonium salts **such** as tetramethylphosphonium chloride, tetrabutylphosphonium chloride, tetramethylphosphonium bromide, tetrabutylphosphonium bromide, tetramethylphosphonium iodide, tetrabutylphosphonium iodide, benzyltrimethylphosphonium chloride, benzyltrimethylphosphonium bromide, benzyltrimethylphosphonium iodide, tetraphenylphosphonium chloride, tetraphenylphosphonium bromide, and tetraphenylphosphonium iodide; phosphorus compounds **such as** triphenylphosphine; organic carboxylate salts **such as** potassium acetate, sodium acetate, potassium benzoate, and sodium benzoate; alkali metal alkolates **such** as sodium alkolate and potassium alkolate; tertiary amines; organotin compounds; organoaluminum compounds; organotitanate compounds such as tetrabutyltitanate; and zinc compounds **such** as zinc chloride.

Illustrative examples of **the** polymerization initiator include monocarboxylic acids including; aliphatic monocarboxylic acids **such** as acetic acid, propionic acid, caprylic acid, nonanoic acid, capric acid, octyl acid, lauryl acid, myristic acid, palmitic acid, stearic acid, isononanoic acid, and arachic acid; aromatic monocarboxylic acids such as benzoic acid and p-butylbenzoic acid.

The weight-average molecular weight of the polyester is preferably 1000 or more, more preferably 1500 or more, and still more preferably 2000 or more, and preferably 50000 or less, more preferably 40000 or less, and still more preferably 30000 or less. Note that the weight-average molecular weight is the weight molecular weight in terms of polystyrene measured with a gel permeation chromatography (GPC) method.

The reaction temperature and the reaction time in the reaction of the polyamine with the polyester are the same as the reaction temperature and the reaction time in the reaction of the lactone represented by the general formula (2) with the carboxylic acid.

In the production of the component (C), an optional monomer may be used in addition to the polyamine and the polyester, as long as it does not impair the advantageous effects of the present invention. Examples of the optional monomer include a polyester in which R in the general formula (1) is a divalent hydrocarbon group having the carbon number of 1 or 11 or more.

The pH of the component (C) may be usually 4 or more and less than 7. The pH may be measured by an indicator method. Specifically, a measurement sample with the dispersant concentration of 0.1 g/mL (22°C), prepared by dissolving the dispersant in acetone, may be measured by dipping this in a pH test paper. As for the pH test paper, the pH test paper capable of measuring the pH in the acidic range (e.g., those with a measurement range of pH 0.0 to 14.0, pH 1.0 to 14.0, or pH 0.5 to 5.0) may be used, e.g., "pH Test Paper for pH 1 to 14" (pH measurement range: pH 1.0 to 14.0) manufactured by As One Corp.

The weight-average molecular weight of the component (C) is preferably 1000 or more, more preferably 1500 or more, and still more preferably 2000 or more, and preferably 50000 or less, more preferably 40000 or less, and still more preferably 30000 or less. Note that the weight-average molecular weight is the weight molecular weight in terms of polystyrene measured with a gel permeation chromatography (GPC) method.

Commercially available products may be used as the component (C). Illustrative examples of the commercially available product of the component (C) include "Solsperse 24000GR", manufactured by Lubrizol Japan.

The content of the component (C) relative to 100% by mass of the non-volatile components in the resin composition is, from the viewpoint to clearly obtain the advantageous effects of the present invention, preferably 0.01% by mass or more, more preferably 0.05% by mass or more, and still more preferably 0.1% by mass or more, and the upper limit thereof is preferably 5% by mass or less, more preferably 3% by mass or less, and still more preferably 1% by mass or less.

The content of the component (C) relative to 100% by mass of the non-volatile components in the resin composition is represented by Cm. From the viewpoint to clearly obtain the advantageous effects of the present invention, the ratio Am/Cm is preferably 0.1 or more, more preferably 0.5 or more, and still more preferably 1 or more, and preferably 10 or less, more preferably 8 or less, and still more preferably 5 or less.

### (D) Magnetic Powder

The resin composition includes (D) a magnetic powder as the component (D). By including the magnetic powder (D) in the resin composition, the specific magnetic permeability of the cured product of the resin composition may be increased and the loss factor may be decreased. The magnetic powder (D) may be used singly, or two or more kinds thereof concurrently.

Particles of the material having the specific magnetic permeability of more than 1 may be used as the magnetic powder (D). As one embodiment of the magnetic powder (D), it is preferable to include any of a nanocrystalline magnetic powder and a small-diameter magnetic powder; and it is more preferable to include a nanocrystalline magnetic powder.

The term "nanocrystalline magnetic powder" refers to the magnetic powder including crystalline particles having a particle diameter of 100 nm or less. There is no particular restriction in the lower limit of the particle diameter of the crystalline particle, but it is preferably 1 nm or more. In particular, the nanocrystalline magnetic powder having a maximum particle diameter of 100 nm or less is preferable. Usually, a single nanocrystalline magnetic powder particle includes a plurality of crystalline particles, and thus the particle of the nanocrystalline magnetic powder may be polycrystalline. The size of the crystalline particle may be observed, for example, by a transmission electron microscopy (TEM). Because the nanocrystalline magnetic powder includes the crystalline particles, in general, this may exhibit peaks that indicate crystallinity in the X-ray diffraction pattern. For example, the bcc crystal structure (body-centered cubic lattice structure) may be cited as the crystal structure possessed by the crystalline particle, but other crystal structures may also be allowed.

Usually, the nanocrystalline magnetic powder is included in the resin composition in the form of particle. The nanocrystalline magnetic powder may include a crystalline particle at least in part of the particle thereof, in which the one including the crystalline particle on the surface layer of the particle is preferable, the one including the crystalline particle throughout the particle is more preferable, and the one consisting of only the crystalline particle is especially preferable.

Usually, the nanocrystalline magnetic powder has a particle diameter in the range of 5.5 µm or more to 20 µm or less. The particle diameter of the nanocrystalline magnetic powder may be measured with a laser diffraction and scattering method based on the Mie scattering theory. Specifically, the particle size distribution of the nanocrystalline magnetic powder is prepared on the basis of a volume standard by using a laser diffraction scattering type particle size distribution measurement instrument, and the diameter thereof may be measured from this particle size distribution. The nanocrystalline magnetic powders that are dispersed in pure water by means of an ultrasonic wave may be preferably used as the measurement sample. Illustrative examples of the laser diffraction scattering type particle size distribution measurement instrument include "MT3000II" manufactured by MicrotracBEL Corp., "LA-960" manufactured by Horiba, Ltd., and "SALD-2200" manufactured by Shimadzu Corp.

The average particle diameter D₅₀ of the nanocrystalline magnetic powder is usually 5.5 µm or more, preferably 5.7 µm or more, more preferably 5.9 µm or more, and usually 20 µm or less, preferably 18 µm or less, and more preferably 16 µm or less. By using the nanocrystalline magnetic powder having the average particle diameter D₅₀ in the range described above, it is possible to improve the specific magnetic permeability, the loss factor, and the mechanical strength. The average particle diameter D₅₀ of the nanocrystalline magnetic powder represents the median diameter on a volume basis and may be measured from the particle size distribution on a volume basis measured by the laser diffraction and scattering method described before.

The volume-based particle size distribution of the nanocrystalline magnetic powder usually follows a normal distribution. Thus, it is possible that the nanocrystalline magnetic powder has a 10%-particle diameter D₁₀, which is smaller than the average particle diameter D₅₀ of the nanocrystalline magnetic powder, and a 90%-particle diameter D₉₀, which is larger than the average particle diameter D₅₀ of the nanocrystalline magnetic powder. Here, the 10%-particle diameter D₁₀ represents the particle diameter when the cumulative volume amount from the small particle diameter side becomes 10% in the particle size distribution on a volume basis. The 90%-particle diameter D₉₀ represents the particle diameter when the cumulative volume amount from the small particle diameter side becomes 90% in the particle size distribution on a volume basis. The 10%-particle diameter D₁₀ and the 90%-particle diameter D₉₀ of the nanocrystalline magnetic powder may be measured from the volume-based particle size distribution measured by the laser diffraction and scattering method described before.

The 10%-particle diameter D₁₀ of the nanocrystalline magnetic powder is preferably more than 2.0 µm, more preferably 2.4 µm or more, and especially preferably 2.8 µm or more. The upper limit thereof is equal to or less than the average particle diameter D₅₀; thus, this may be, for example, 10 µm or less, 8 µm or less, and 6 µm or less. When the 10%-particle diameter D₁₀ of the nanocrystalline magnetic powder is in the range described above, it is possible to improve the specific magnetic permeability, the loss factor, and the mechanical strength.

The upper limit of the 90%-particle diameter D₉₀ of the nanocrystalline magnetic powder is preferably 60 µm or less, more preferably 50 µm or less, and especially preferably 40 µm or less. The lower limit thereof is more than or equal to the average particle diameter D₅₀; thus, this may be, for example, 6 µm or more, 8 µm or more, and 10 µm or more. When the 90%-particle diameter D₉₀ of the nanocrystalline magnetic powder is in the range described above, it is possible to improve the specific magnetic permeability, the loss factor, and the mechanical strength.

The difference between the 10%-particle diameter D₁₀ and the 90%-particle diameter D₉₀ of the nanocrystalline magnetic powder, i.e., D₉₀-D₁₀, is preferably 1 µm or more, more preferably 3 µm or more, especially preferably 5 µm or more, and preferably 40 µm or less, more preferably 35 µm or less, and especially preferably 30 µm or less. When the difference D₉₀-D₁₀ is in the range described above, it is possible to improve the specific magnetic permeability, the loss factor, and the mechanical strength.

The ratio of the 10%-particle diameter D₁₀ and the 90%-particle diameter D₉₀ of the nanocrystalline magnetic powder, i.e., D₉₀/D₁₀, is preferably 1.1 or more, more preferably 2 or more, especially preferably 3 or more, and preferably 10 or less, more preferably 8 or less, and especially preferably 6 or less. When the ratio D₉₀/D₁₀ is in the range described above, it is possible to improve the specific magnetic permeability, the loss factor, and the mechanical strength.

The nanocrystalline magnetic powder may be the magnetic material particle having the specific magnetic permeability of more than 1. Usually, this magnetic material is an inorganic material, in which it may be a soft magnetic material or a hard magnetic material. In addition, the magnetic material may be used singly or as a combination of two or more of those described above. In particular, from the viewpoint of suppressing uneven distribution of the nanocrystalline magnetic powders, a soft magnetic material is preferable as the magnetic material included in the nanocrystalline magnetic powder.

Illustrative examples of the magnetic material included in the nanocrystalline magnetic powder include a magnetic metal oxide and a magnetic metal. In particular, it is preferable that the magnetic material contained in the nanocrystalline magnetic powder includes iron (Fe). Therefore, illustrative examples of the magnetic material that is contained in the nanocrystalline magnetic powder include an iron alloy magnetic material having crystallinity and a ferrite magnetic material having crystallinity. From the viewpoint of the magnetic permeability and the loss factor, it is preferable that the magnetic material contained in the nanocrystalline magnetic powder has a composition that further contains one or more elements selected from the group consisting of Nb, Hf, Zr, Ta, Mo, **W,** and V in combination with Fe.

Illustrative examples of the preferable magnetic material contained in the nanocrystalline magnetic powder include the magnetic materials described in Japanese Patent Application Laid-open Nos. 2021-158343, 2021-141267, 2019-31463, and 2021-11602.

Among the above examples, from the viewpoint of the magnetic permeability and the loss factor, a Fe-Si-Nb-B alloy powder is preferable. The Fe-Si-Nb-B alloy powder represents the magnetic powder formed from an alloy containing Fe, Si, Nb, and B.

It is preferable that the nanocrystalline magnetic powder includes the magnetic materials mentioned above, and includes only the magnetic materials mentioned above. In addition, the nanocrystalline magnetic powder may be used singly or as a combination of two or more of those described above.

The nanocrystalline magnetic powder may be produced, for example, by an atomization method. Specific examples of the method for producing the nanocrystalline magnetic powder include those described in Japanese Patent Application Laid-open Nos. 2021-141267 and 2021-158343.

The nanocrystalline magnetic powders that are commercially available may be used. Illustrative examples of the commercially available magnetic powder containing the nanocrystalline magnetic powder include "KUAMET NC1-53 µm", "KUAMET NC1-38 µm", and "ATFINE-NC1 PF10FA", all being manufactured by Epson Atmix Corp. If the nanocrystalline magnetic powder is obtained from the market, commercially available magnetic powder may be used after having been classified, as needed.

The nanocrystalline magnetic powder is preferably spherical. The value obtained by dividing the length of the longitude axis by the length of the short axis (aspect ratio) of the particle of the nanocrystalline magnetic powder is preferably 2 or less, more preferably 1.5 or less, still more preferably 1.2 or less, and usually 1 or more, preferably more than 1, and more preferably 1.05 or more.

The content (% by mass) of the nanocrystalline magnetic powder relative to 100% by mass of the non-volatile components in the resin composition is preferably 30% by mass or more, more preferably 40% by mass or more, still more preferably 50% by mass or more, and preferably 90% by mass or less, more preferably 85% by mass or less, and still more preferably 80% by mass or less. When the content of the nanocrystalline magnetic powder is in the range described above, it is possible to improve the specific magnetic permeability, the loss factor, and the mechanical strength.

The content (% by volume) of the nanocrystalline magnetic powder relative to 100% by volume of the non-volatile components in the resin composition is preferably 23% by volume or more, more preferably 25% by volume or more, still more preferably 28% by volume or more, and preferably 60% by volume or less, more preferably 50% by volume or less, and still more preferably 40% by volume or less. When the content of the nanocrystalline magnetic powder is in the range described above, it is possible to improve the specific magnetic permeability, the loss factor, and the mechanical strength.

Usually, a small-diameter magnetic powder is included in the resin composition in the form of a particle. This small-diameter magnetic powder usually has a particle diameter of 2 µm or less. The particle diameter of the small-diameter magnetic powder may be measured by the same method as that for the nanocrystalline magnetic powder.

The average particle diameter D₅₀ of the small-diameter magnetic powder is usually 2 µm or less, preferably 1.5 µm or less, and more preferably 1 µm or less. The lower limit thereof may be 0.01 µm or more, 0.1 µm or more, or the like. By using the small-diameter magnetic powder having the average particle diameter D₅₀ in the range described above, it is possible to improve the specific magnetic permeability, the loss factor, and the mechanical strength. The average particle diameter D₅₀ of the small-diameter magnetic raw material powder represents the median diameter on a volume basis and may be measured by the same method as that for the average particle diameter D₅₀ of the nanocrystalline magnetic powder.

The volume-based particle size distribution of the small-diameter magnetic powder usually follows a normal distribution. Thus, the small-diameter magnetic powder may have a 10%-particle diameter D₁₀, which is smaller than the average particle diameter D₅₀ of the small-diameter magnetic powder, and a 90%-particle diameter D₉₀, which is larger than the average particle diameter D₅₀ of the small-diameter magnetic powder. The 10%-particle diameter D₁₀ and the 90%-particle diameter D₉₀ of the small-diameter magnetic powder may be measured in the same way as the 10%-particle diameter D₁₀ and the 90%-particle diameter D₉₀ of the nanocrystalline magnetic powder.

The 10%-particle diameter D₁₀ of the small-diameter magnetic powder is preferably 0.01 µm or more, more preferably 0.02 µm or more, and especially preferably 0.03 µm or more. The upper limit thereof is equal to or less than the average particle diameter D₅₀; thus, this may be, for example, 1 µm or less, 0.7 µm or less, and 0.5 µm or less. When the 10%-particle diameter D₁₀ of the small-diameter magnetic powder is in the range described above, it is possible to improve the specific magnetic permeability, the loss factor, and the mechanical strength.

The 90%-particle diameter D₉₀ of the small-diameter magnetic powder is preferably less than 5.5 µm, more preferably 4 µm or less, and especially preferably 2 µm or less. The lower limit thereof is equal to or more than the average particle diameter D₅₀; thus, this may be, for example, 0.5 µm or more, 0.8 µm or more, and 1 µm or more. When the 90%-particle diameter D₉₀ of the small-diameter magnetic powder is in the range described above, it is possible to improve the specific magnetic permeability, the loss factor, and the mechanical strength.

The difference between the 10%-particle diameter D₁₀ and the 90%-particle diameter D₉₀ of the small-diameter magnetic powder, i.e., D₉₀-D₁₀, is preferably 0.1 µm or more, more preferably 0.3 µm or more, especially preferably 0.5 µm or more, and preferably 5 µm or less, more preferably 4 µm or less, and especially preferably 3 µm or less. When the difference D₉₀-D₁₀ is in the range described above, it is possible to improve the specific magnetic permeability, the loss factor, and the mechanical strength.

The ratio of the 10%-particle diameter D₁₀ and the 90%-particle diameter D₉₀ of the small-diameter magnetic powder, i.e., D₉₀/D₁₀, is preferably 1.1 or more, more preferably 1.5 or more, and especially preferably 2 or more, and preferably 50 or less, more preferably 40 or less, and especially preferably 30 or less. When the ratio D₉₀/D₁₀ is in the range described above, it is possible to improve the specific magnetic permeability, the loss factor, and the mechanical strength.

The small-diameter magnetic powder may be the nanocrystalline magnetic powder containing a crystalline particle, an amorphous magnetic powder not containing a crystalline particle, a crystalline magnetic powder other than the nanocrystalline magnetic powder, or a combination of these. The nanocrystalline magnetic powder is as described above. An amorphous magnetic material is amorphous, so that usually, this does not exhibit specific peaks in the X-ray diffraction pattern that indicate crystallinity. In general, a broad pattern without peaks indicating crystallinity appears in the X-ray diffraction pattern of the amorphous magnetic powder.

The small-diameter magnetic powder may be a magnetic material particle having a specific magnetic permeability of more than **1.** Usually, this magnetic material is an inorganic material, in which it may be a soft magnetic material or a hard magnetic material. In addition, the magnetic material may be used singly or as a combination of two or more of those described above. In particular, from the viewpoint of suppressing uneven distribution of the small-diameter magnetic powder, a soft magnetic material is preferable as the magnetic material contained in the small-diameter magnetic powder.

Illustrative examples of the magnetic material contained in the small-diameter magnetic powder include a magnetic metal oxide material and a magnetic metal material.

Illustrative examples of the magnetic metal oxide material include a ferrite type magnetic material; and an iron oxide material such as iron oxide powder (III) and triiron tetraoxide powder. Among these, a ferrite type magnetic material is preferable. The ferrite type magnetic material is usually a composite oxide mainly formed of iron oxides and is chemically stable. Therefore, using the ferrite type magnetic material offers advantages such as a high corrosion resistance, a low risk of ignition, and a resistance to demagnetization.

Illustrative examples of the ferrite type magnetic material include a Fe-Mn type ferrite, a Fe-Mn-Mg type ferrite, a Fe-Mn-Mg-Sr type ferrite, a Fe-Mg-Zn type ferrite, a Fe-Mg-Sr type ferrite, a Fe-Zn-Mn type ferrite, a Fe-Cu-Zn type ferrite, a Fe-Ni-Zn type ferrite, a Fe-Ni-Zn-Cu type ferrite, a Fe-Ba-Zn type ferrite, a Fe-Ba-Mg type ferrite, a Fe-Ba-Ni type ferrite, a Fe-Ba-Co type ferrite, a Fe-Ba-Ni-Co type ferrite, and a Fe-Y type ferrite.

Among the ferrite type magnetic materials, from the viewpoint to clearly obtain the intended effects of the present invention, a ferrite that contains at least one element selected from the group consisting of Mn, Zn, Ni, and Cu is preferable; and a ferrite that contains Mn is especially preferable. Therefore, illustrative examples of the preferable ferrite type magnetic material include a Fe-Mn type ferrite, a Fe-Mn-Mg type ferrite, a Fe-Mn-Mg-Sr type ferrite, a Fe-Mg-Zn type ferrite, a Fe-Zn-Mn type ferrite, a Fe-Cu-Zn type ferrite, a Fe-Ni-Zn type ferrite, a Fe-Ni-Zn-Cu type ferrite, a Fe-Ba-Zn type ferrite, a Fe-Ba-Ni type ferrite, and a Fe-Ba-Ni-Co type ferrite. Among them, a Fe-Mn type ferrite, a Fe-Mn-Mg type ferrite, a Fe-Mn-Mg-Sr type ferrite, and a Fe-Zn-Mn type ferrite are preferable, and a Fe-Mn type ferrite is especially preferable. The Fe-Mn ferrite represents the ferrite that contains Fe and Mn.

Illustrative examples of the magnetic metal material include a pure iron; and crystalline or amorphous alloy magnetic materials such as a Fe-Si type alloy, a Fe-Si-Al type alloy, a Fe-Cr type alloy, a Fe-Cr-Si type alloy, a Fe-Ni-Cr type alloy, a Fe-Cr-Al type alloy, a Fe-Ni type alloy, a Fe-Ni-B type alloy, a Fe-Ni-Mo type alloy, a Fe-Ni-Mo-Cu type alloy, a Fe-Co type alloy, a Fe-Ni-Co type alloy, and a Co-based amorphous alloy. Among the magnetic metal materials, an iron alloy type magnetic material is more preferable. From the viewpoint to clearly obtain the intended effects of the present invention, an iron alloy type magnetic material containing Fe, as well as at least one element selected from the group consisting of Si, Cr, Al, Ni, and Co is preferable, and a Fe-Si-Cr type alloy is especially preferable. The Fe-Si-Cr type alloy material represents an alloy containing Fe, Si, and Cr.

As the magnetic material included in the small-diameter magnetic powder, the magnetic material described as the magnetic material of the nanocrystalline magnetic powder may also be used. The magnetic material included in the small-diameter magnetic powder and the magnetic material of the nanocrystalline magnetic powder may be the same or different.

It is preferable that the small-diameter magnetic powder includes the magnetic material described above, or includes only the magnetic material described above. In addition, the small-diameter magnetic powder may be used one kind singly or as a combination of two or more kinds thereof.

Small-diameter magnetic powders that are commercially available may be used. Specific examples of the commercially available magnetic powder include: "MZ03S", "M05S", "M001", and "MZ05S", all of which are manufactured by Powdertech Co., Ltd.; "PST-S" manufactured by Sanyo Special Steel Co., Ltd.; "AW2-08", "AW2-08PF20F", "AW2-08PF10F", "AW2-08PF3F", "Fe-3.5Si-4.5CrPF20F", "Fe-50NiPF20F", "Fe-80Ni-4MoPF20F", "ATFINE-NC1·PF5FA", and "ATFINE-NC1·PF3FA", all of which are manufactured by Epson Atmix Corp.; "CVD iron powder (0.7 µm)","LD-M", "LD-MH", "KNI-106", "KNI-106GSM", "KNI-106GS", "KNI-109", "KNI-109GSM", and "KNI-109GS", all of which are manufactured by JFE Chemical Corp.; "KNS-415", "BSF-547", "BSF-029", "BSN-125", "BSN-125", "BSN-714", "BSN-828", "S-1281", "S-1641", "S-1651", "S-1470", "S-1511", and "S-2430", all of which are manufactured by Toda Kogyo Corp.; "JR09P2" manufactured by Japan Metals and Chemicals Co., Ltd.; "Nanotek" manufactured by CIK-NanoTek Corp.; "JEMK-S" and "JEMK-H", which are manufactured by Kinsei Matec Co., Ltd.; "Yttrium iron oxide" manufactured by Aldrich; and "MA-RCO-5" manufactured by DOWA Electronics Materials Co., Ltd. When the small-diameter magnetic powder is obtained from the market, commercially available magnetic powders may be used after having been classified, as needed.

The small-diameter magnetic powder is preferably spherical. The range of the aspect ratio of the particle of the small-diameter magnetic powder may be the same as the range of the aspect ratio of the nanocrystalline magnetic powder. The aspect ratio of the small-diameter magnetic powder and the aspect ratio of the nanocrystalline magnetic powder may be the same or different.

The content (% by mass) of the small-diameter magnetic powder relative to 100% by mass of the non-volatile components in the resin composition is preferably 1% by mass or more, more preferably 5% by mass or more, and especially preferably 8% by mass or more, and preferably 20% by mass or less, more preferably 15% by mass or less, and still more preferably 10% by mass or less. When the content of the small-diameter magnetic powder is in the range described above, it is possible to improve the specific magnetic permeability, the loss factor, and the mechanical strength.

The content (% by volume) of the small-diameter magnetic powder relative to 100% by volume of the non-volatile components in the resin composition is preferably 5% by volume or more, more preferably 6% by volume or more, and especially preferably 7% by volume or more, and preferably 30% by volume or less, more preferably 26% by volume or less, and still more preferably 22% by volume or less. When the small-diameter magnetic powder with the content described above is used, it is possible to improve the specific magnetic permeability, the loss factor, and the mechanical strength.

Relative to 100% by volume of the non-volatile components in the resin composition, the content (% by volume) of the nanocrystalline magnetic powder is represented by "V(A)" and the content (% by volume) of the small-diameter magnetic powder is represented by "V(B)". In this case, the volume ratio of the nanocrystalline magnetic powder to the small-diameter magnetic powder included in the resin composition (nanocrystalline magnetic powder/small-diameter magnetic powder) may be expressed as "V(A)/V(B)". This volume ratio V(A)/V(B) is usually 0.8 or more, preferably 1 or more, more preferably 1.2 or more, and especially preferably 1.4 or more, and usually 12 or less, preferably 8.4 or less, more preferably 7.0 or less, still more preferably 6.0 or less, and especially preferably 5.0 or less. When the volume ratio, V(A)/V(B), is in the range described above, it is possible to improve the specific magnetic permeability, the loss factor, and the mechanical strength.

The total amount (% by volume) of the nanocrystalline magnetic powder and the small-diameter magnetic powder included in the resin composition relative to 100% by volume of the non-volatile components in the resin composition may be expressed as "V(A)+V(B)". This total amount (% by volume), V(A)+V(B), is usually 28% by volume or more, preferably 34% by volume or more, more preferably 38% by volume or more, especially preferably 40% by volume or more, and preferably 72% by volume or less, more preferably 68% by volume or less, still more preferably 64% by volume or less, and especially preferably 60% by volume or less. When the total amount (% by volume) of the nanocrystalline magnetic powder and the small-diameter magnetic powder, V(A)+V(B), is in the range described above, it is possible to improve the specific magnetic permeability, the loss factor, and the mechanical strength.

Relative to 100 % by mass of the non-volatile components in the resin composition, the content (% by mass) of the nanocrystalline magnetic powder is represented by "M(A)" and the content (% by mass) of the small-diameter magnetic powder is represented by "M(B)". In this case, the mass ratio of the nanocrystalline magnetic powder to the small-diameter magnetic powder included in the resin composition ((A) nanocrystalline magnetic powder/(B) small-diameter magnetic powder) may be expressed as "M(A)/M(B)". This mass ratio M(A)/M(B) is preferably 1 or more, more preferably 3 or more, and especially preferably 5 or more, and preferably 15 or less, more preferably 10 or less, and especially preferably 9 or less. When the mass ratio M(A)/M(B) is in the range described above, it is possible to improve the specific magnetic permeability, the loss factor, and the mechanical strength.

The total amount (% by mass) of the nanocrystalline magnetic powder and the small-diameter magnetic powder included in the resin composition may be expressed as "M(A)+M(B)" relative to 100% by mass of the non-volatile components in the resin composition. The total amount (% by mass), M(A)+M(B), is preferably 40% by mass or more, more preferably 45% by mass or more, still more preferably 50% by mass or more, especially preferably 53% by mass or more, and preferably 95% by mass or less, more preferably 90% by mass or less, and especially preferably 88% by mass or less. When the total amount (% by mass), M(A) + M(B), is in the range described above, it is possible to improve the specific magnetic permeability, the loss factor, and the mechanical strength.

The magnetic powder (D) may further include a magnetic powder that is different from the nanocrystalline magnetic powder and the small-diameter magnetic powder. The magnetic powder that is different from the nanocrystalline magnetic powder and the small-diameter magnetic powder is sometimes referred to as "intermediate magnetic powder".

The intermediate magnetic powder includes the following (D1) and (D2) magnetic powders.
(D1) Magnetic powder that is the nanocrystalline magnetic powder and has a particle size of more than 2 µm and less than 5.5 µm.
(D2) Magnetic powder other than the nanocrystalline magnetic powder and has a particle size of more than 2 µm and 20 µm or less.

By including the intermediate magnetic powder in the resin composition, the ratio of the magnetic powder in the resin composition may be increased, so that the specific magnetic permeability of the cured product of the resin composition may be increased. Usually, the intermediate magnetic powder may increase the loss factor of the cured product, but the degree of the increase in the loss factor may be suppressed because the intermediate magnetic powder has a small particle size. Therefore, the intermediate magnetic powder may usually improve the specific magnetic permeability while suppressing the increase in the loss factor.

Specifically, the average particle diameter D₅₀ of the intermediate magnetic powder is usually more than 2 µm, preferably 2.5 µm or more, and more preferably 3 µm or more, and usually less than the average particle diameter of the nanocrystalline magnetic powder, preferably less than 5.5 µm, and more preferably 5 µm or less. When the intermediate magnetic powder having the average particle diameter D₅₀ in the range described above is used, it is possible to improve the specific magnetic permeability, the loss factor, and the mechanical strength. The average particle diameter D₅₀ of the intermediate magnetic powder represents the median diameter on a volume basis, and this may be measured by the same method as that for the average particle diameter D₅₀ of the nanocrystalline magnetic powder.

The volume-based particle size distribution of the intermediate magnetic powder usually follows a normal distribution. Thus, the intermediate magnetic powder may have a 10%-particle diameter D₁₀, which is smaller than the average particle diameter D₅₀ of the intermediate magnetic raw material powder, and a 90%-particle diameter D₉₀, which is larger than the average particle diameter D₅₀ of the intermediate magnetic powder. The 10%-particle diameter D₁₀ and the 90%-particle diameter D₉₀ of the intermediate magnetic raw material powder may be measured in the same way as the 10%-particle diameter D₁₀ and the 90%-particle diameter D₉₀ of the nanocrystalline magnetic powder.

The 10%-particle diameter D₁₀ of the intermediate magnetic powder is preferably 1 µm or more, more preferably 1.3 µm or more, and still more preferably 1.5 µm or more. The upper limit thereof is equal to or less than the average particle diameter D₅₀, for example, 5 µm or less, 4 µm or less, and 3 µm or less. When the 10%-particle diameter D₁₀ of the intermediate magnetic powder is in the range described above, it is possible to improve the specific magnetic permeability, the loss factor, and the mechanical strength.

The 90%-particle diameter D₉₀ of the intermediate magnetic powder is preferably less than 10 µm, more preferably 9 µm or less, and especially preferably 8 µm or less. The lower limit thereof is equal to or less than the average particle diameter D₅₀; thus, this may be, for example, 3 µm or more, 4 µm or more, and 5 µm or more. When the 90%-particle diameter D₉₀ of the intermediate magnetic powder is in the range described above, it is possible to improve the specific magnetic permeability, the loss factor, and the mechanical strength.

The difference between the 10%-particle diameter D₁₀ and the 90%-particle diameter D₉₀ of the intermediate magnetic powder, i.e., D₉₀-D₁₀, is preferably 0.1 µm or more, more preferably 1 µm or more, especially preferably 2 µm or more, and preferably 9 µm or less, more preferably 7 µm or less, and especially preferably 5 µm or less. When the difference D₉₀-D₁₀ is in the range described above, it is possible to improve the specific magnetic permeability, the loss factor, and the mechanical strength.

The ratio of the 10%-particle diameter D₁₀ and the 90%-particle diameter D₉₀ of the intermediate magnetic powder, i.e., D₉₀/D₁₀, is preferably 1.1 or more, more preferably 1.5 or more, especially preferably 2 or more, and preferably 10 or less, more preferably 8 or less, and especially preferably 6 or less. When the ratio D₉₀/D₁₀ is in the range described above, it is possible to improve the specific magnetic permeability, the loss factor, and the mechanical strength.

The intermediate magnetic powder may be the nanocrystalline magnetic powder containing a crystalline particle, an amorphous magnetic powder not containing a crystalline particle, a crystalline magnetic powder other than the nanocrystalline magnetic powder, or a combination of these. The intermediate magnetic powder may be the magnetic material particle having the specific magnetic permeability of more than 1. The magnetic material described as the magnetic material of the small-diameter magnetic powder may be used as the magnetic material included in the intermediate magnetic powder. The magnetic material included in the intermediate magnetic powder and the magnetic material of the small-diameter magnetic powder may be the same or different. It is preferable that the intermediate magnetic powder includes the magnetic material described above, or includes only the magnetic material described above. In addition, the intermediate magnetic powder may be used singly or as a combination of two or more of those described above.

The intermediate magnetic powder that is commercially available may be used. Specific examples of the commercially available magnetic powder are the same as those for the small-diameter magnetic powder. When the intermediate magnetic powder is obtained from the market, commercially available magnetic powder may be used after having been classified, as needed.

The intermediate magnetic powder is preferably spherical. The range of the aspect ratio of the particle of the intermediate magnetic powder may be the same as the range of the aspect ratio of the nanocrystalline magnetic powder. The aspect ratio of the intermediate magnetic powder and the aspect ratio of the nanocrystalline magnetic powder may be the same or different. The aspect ratio of the intermediate magnetic powder and the aspect ratio of the small-diameter magnetic powder may be the same or different.

The content (% by volume) of the intermediate magnetic powder relative to 100% by volume of the non-volatile components in the resin composition may be 0% by volume, or more than 0% by volume; and it is preferably 1% by volume or more, more preferably 3% by volume or more, and especially preferably 5% by volume or more, and preferably 25% by volume or less, more preferably 15% by volume or less, and especially preferably 13% by volume or less. When the content of the intermediate magnetic powder is in the range described above, it is possible to improve the specific magnetic permeability, the loss factor, and the mechanical strength.

The content (% by mass) of the intermediate magnetic powder relative to 100% by mass of the non-volatile components in the resin composition may be 0% by mass, or more than 0% by mass; and it is preferably 1% by mass or more, more preferably 5% by mass or more, and especially preferably 8% by mass or more, and preferably 20% by mass or less, more preferably 15% by mass or less, and still more preferably 10% by mass or less. When the content of the intermediate magnetic powder is in the range described above, it is possible to improve the specific magnetic permeability, the loss factor, and the mechanical strength.

The content of the intermediate magnetic powder (% by volume) relative to 100 % by volume of the non-volatile components in the resin composition is expressed as "V(C)". In this case, the volume ratio of the nanocrystalline magnetic powder and the intermediate magnetic powder in the resin composition (intermediate magnetic powder/nanocrystalline magnetic powder) may be expressed as "V(C)/V(A)". The volume ratio, V(C)/V(A), may be 0, or more than 0, and this is preferably 0.01 or more, more preferably 0.1 or more, and preferably 1.0 or less, more preferably 0.9 or less, and especially preferably 0.8 or less. When the volume ratio, V(C)/V(A), is in the range described above, it is possible to improve the specific magnetic permeability, the loss factor, and the mechanical strength.

The volume ratio of the small-diameter magnetic powder and the intermediate magnetic powder in the resin composition (intermediate magnetic powder/small-diameter magnetic powder) may be expressed as "V(C)/V(B)". This volume ratio, V(C)/V(B), may be 0, or more than 0, and this is preferably 0.01 or more, more preferably 0.1 or more, and preferably 8 or less, more preferably 5 or less, and especially preferably 2 or less. When the volume ratio, V(C)/V(B), is in the range described above, it is possible to improve the specific magnetic permeability, the loss factor, and the mechanical strength.

The total content (% by volume) of the nanocrystalline magnetic powder, the small-diameter magnetic powder, and the intermediate magnetic powder relative to 100% by volume of the non-volatile components in the resin composition is preferably 70% by volume or more, more preferably 75% by volume or more, especially preferably 80% by volume or more, and preferably 95% by volume or less, more preferably 90% by volume or less, and especially preferably 85% by volume or less. When the total content (% by volume) of the nanocrystalline magnetic powder, the small-diameter magnetic powder, and the intermediate magnetic powder is in the range described above, it is possible to improve the specific magnetic permeability, the loss factor, and the mechanical strength.

The total content (% by volume) of the nanocrystalline magnetic powder, the small-diameter magnetic powder, and the intermediate magnetic powder relative to 100% by volume of the total content of the magnetic powders in the resin composition is preferably 50% by volume or more, more preferably 60% by volume or more, especially preferably 70% by volume or more, and usually 100% by volume or less. A larger value thereof indicates that there are fewer giant magnetic powders having the particle size of more than 20 µm in the resin composition. When the total content (% by volume) of the nanocrystalline magnetic powder, the small-diameter magnetic powder, and the intermediate magnetic powder is in the range described above, it is possible to improve the specific magnetic permeability, the loss factor, and the mechanical strength.

The content (% by mass) of the intermediate magnetic powder relative to 100% by mass of the non-volatile components in the resin composition is expressed as "M(C)". In this case, the mass ratio of the nanocrystalline magnetic powder and the intermediate magnetic powder in the resin composition (intermediate magnetic powder/nanocrystalline magnetic powder) may be expressed as "M(C)/M(A)". This mass ratio, M(C)/M(A), may be 0, or more than 0, and this is preferably 1 or more, more preferably 3 or more, especially preferably 5 or more, and preferably 15 or less, more preferably 10 or less, and especially preferably 9 or less. When the mass ratio, M(C)/M(A), is in the range described above, it is possible to improve the specific magnetic permeability, the loss factor, and the mechanical strength.

The mass ratio of the small-diameter magnetic powder and the intermediate magnetic powder in the resin composition (intermediate magnetic powder/small-diameter magnetic powder) may be expressed as "M(C)/M(B)". This mass ratio, M(C)/M(B), may be 0, or more than 0, and this is preferably 0.01 or more, more preferably 0.1 or more, especially preferably 0.5 or more, and preferably 8 or less, more preferably 5 or less, and especially preferably 1.5 or less. When the mass ratio, M(C)/M(B), is in the range described above, it is possible to improve the specific magnetic permeability, the loss factor, and the mechanical strength.

The total content (% by mass) of the nanocrystalline magnetic powder, the small-diameter magnetic powder, and the intermediate magnetic powder relative to 100% by mass of the non-volatile components in the resin composition is preferably 40% by mass or more, more preferably 50% by mass or more, especially preferably 60% by mass or more, and preferably 99% by mass or less, and more preferably 98% by mass or less. When the total content (% by mass) of the nanocrystalline magnetic powder, the small-diameter magnetic powder, and the intermediate magnetic powder is in the range described above, it is possible to improve the specific magnetic permeability, the loss factor, and the mechanical strength.

The total content (% by mass) of the nanocrystalline magnetic powder, the small-diameter magnetic powder, and the intermediate magnetic powder relative to 100% by mass of the total content of the magnetic powders in the resin composition is preferably 50% by mass or more, more preferably 60% by mass or more, especially preferably 70% by mass or more, and usually 100% by mass or less. A larger value thereof indicates that there are fewer giant magnetic powders having the particle size of more than 20 µm in the resin composition. When the total content (% by mass) of the nanocrystalline magnetic powder, the small-diameter magnetic powder, and the intermediate magnetic powder is in the range described above, it is possible to improve the specific magnetic permeability, the loss factor, and the mechanical strength.

Relative to 100% by mass of the non-volatile components in the resin composition, the content of the magnetic powder (D) is expressed as Dm, and the content of the component (C) is expressed as Cm. The ratio Dm/Cm is preferably 100 or more, more preferably 130 or more, and still more preferably 150 or more, and preferably 800 or less, more preferably 600 or less, and still more preferably 550 or less.

The content (% by volume) of the magnetic powder (D) relative to 100% by volume of the non-volatile components in the resin composition is preferably 70% by volume or more, preferably 75% by volume or more, especially preferably 80% by volume or more, and preferably 95% by volume or less, more preferably 90% by volume or less, and especially preferably 85% by volume or less. When the content of the magnetic powder (D) is in the range described above, it is possible to improve the specific magnetic permeability, the loss factor, and the mechanical strength.

The content (% by mass) of the magnetic powder (D) relative to 100% by mass of the non-volatile components in the resin composition is preferably 40% by mass or more, more preferably 50% by mass or more, especially preferably 60% by mass or more, and preferably 99% by mass or less, and more preferably 98% by mass or less. When the content of the magnetic powder (D) is in the range described above, it is possible to improve the specific magnetic permeability, the loss factor, and the mechanical strength.

### (E) Solvent

The resin composition may further include (E) a solvent as a volatile component, in combination with the non-volatile components such as the components (A) through (D) described above.

An organic solvent is usually used as the solvent (E). Illustrative examples of the organic solvent include: ketone type solvents such as acetone, methyl ethyl ketone, methyl isobutyl ketone, and cyclohexanone; ester type solvents such as methyl acetate, ethyl acetate, butyl acetate, isobutyl acetate, isoamyl acetate, methyl propionate, ethyl propionate, and γ-butyrolactone; ether type solvents such as tetrahydropyran, tetrahydrofuran, 1,4-dioxane, diethyl ether, diisopropyl ether, dibutyl ether, and diphenyl ether; alcohol type solvents such as methanol, ethanol, propanol, butanol, and ethyleneglycol; ether ester type solvents such as 2-ethoxyethyl acetate, propyleneglycol monomethyl ether acetate, diethyleneglycol monoethyl ether acetate, ethyldiglycol acetate, γ-butyrolactone, and methyl methoxypropionate; ester alcohol type solvents such as methyl lactate, ethyl lactate, and methyl 2-hydroxyisobutyrate; ether alcohol type solvents such as 2-methoxypropanol, 2-methoxyethanol, 2-ethoxyethanol, propyleneglycol monomethyl ether, and diethyleneglycol monobutyl ether (butyl carbitol); amide type solvents such as N,N-dimethylformamide, N,N-dimethylacetamide, and N-methyl-2-pyrrolidone; sulfoxide type solvents such as dimethyl sulfoxide; nitrile type solvents such as acetonitrile and propionitrile; aliphatic hydrocarbon type solvents such as hexane, cyclopentane, cyclohexane, and methylcyclohexane; and aromatic hydrocarbon type solvents such as benzene, toluene, xylene, ethylbenzene, and trimethylbenzene. Among these, an aliphatic hydrocarbon type solvent and a ketone type solvent are preferable as the solvent (E). The solvent (E) may be used singly or as a combination of two or more of those described above.

From the viewpoints of improving the peelability from the support in the resin sheet and of decreasing the tackiness of the resin composition layer, the amount of the solvent (E) relative to the total mass of the resin composition is preferably 0.5% by mass or more, more preferably 1% by mass or more, and still more preferably 1.5% by mass or more. From the viewpoint of easiness in coating by decreasing the viscosity of a resin varnish in the production of the resin sheet, the upper limit thereof is preferably 15% by mass or less, more preferably 10% by mass or less, and still more preferably 8% by mass or less.

### (F) Curing Agent

The resin composition may contain a curing agent (F) as the component (F), in combination with the components (A) through (D). The curing agent (F) as the component (F) does not include those that fall under the components (A) through (E) described above. In the curing agent (F), there are an epoxy resin curing agent that has the function to cure the epoxy resin (B) and a curing accelerator that has the function to accelerate the curing speed of the epoxy resin (B). The curing accelerator is usually used together with the epoxy resin curing agent. It is preferable that the resin composition includes the epoxy resin curing agent as the curing agent (F).

### Epoxy Resin Curing Agent

The epoxy resin curing agent is usually capable of curing the resin composition by reacting with the epoxy resin (B). Illustrative examples of the epoxy resin curing agent include a phenol type epoxy resin curing agent, a naphthol type epoxy resin curing agent, an active ester type epoxy resin curing agent, an acid anhydride type epoxy resin curing agent, a benzoxazine type epoxy resin curing agent, a cyanate ester type epoxy resin curing agent, and an imidazole type epoxy resin curing agent. As for the epoxy resin curing agent, one or more curing agents selected from a phenol type epoxy resin curing agent and a naphthol type epoxy resin curing agent are preferable, and a phenol type epoxy resin curing agent is more preferable. The epoxy resin curing agent may be used singly, or as a mixture of two or more kinds thereof may be used in combination.

From the viewpoints of a heat resistance and a water resistance, a phenol type epoxy resin curing agent having a novolac structure or a naphthol type epoxy resin curing agent having a novolac structure is preferable as the phenol type epoxy resin curing agent and the naphthol type epoxy resin curing agent. As for the phenol type epoxy resin curing agent, a nitrogen-containing phenol type epoxy resin curing agent is preferable, and a phenol type epoxy resin curing agent containing a triazine skeleton is more preferable, and a phenolic novolac epoxy resin curing agent containing a triazine skeleton is still more preferable.

Specific examples of the phenol type epoxy resin curing agent and the naphthol type epoxy resin curing agent include: "MEH-7700", "MEH-7810", and "MEH-7851", all of which are manufactured by Meiwa Plastic Industries, Ltd.; "NHN", "CBN", and "GPH", all of which are manufactured by Nippon Kayaku Co., Ltd.; "SN170", "SN180", "SN190", "SN475", "SN485", "SN495V", "SN375", and "SN395", all of which are manufactured by Nippon Steel Sumikin Chemical Co., Ltd.; and "TD-2090", "LA-7052", "LA-7054", "LA-1356", "LA-3018-50P", "EXB-9500", "HPC-9500", "KA-1160, "KA-1163", and "KA-1165", all of which are manufactured by DIC Corp.; and "GDP-6115L" and "GDP-6115H", both of which are manufactured by Gun Ei Chemical Industry Co., Ltd.

There is no particular restriction in the active ester type curing agent. In general, compounds having two or more ester groups having a high reactivity in one molecule can be preferably used. Illustrative examples of the highly reactive ester groups include phenol esters, thiophenol esters, N-hydroxylamine esters, and esters of heterocyclic hydroxy compounds. The active ester type epoxy resin curing agent is preferably the compound that is obtained by a condensation reaction of a carboxylic acid compound and/or a thiocarboxylic acid compound with a hydroxy compound and/or a thiol compound. In particular, from a viewpoint to enhance a heat resistance, the active ester type epoxy resin curing agent obtained from a carboxylic acid compound and a hydroxy compound is preferable, and the active ester type epoxy resin curing agent obtained from a carboxylic acid compound and a phenol compound and/or a naphthol compound is more preferable. Illustrative examples of the carboxylic acid compound include benzoic acid, acetic acid, succinic acid, maleic acid, itaconic acid, phthalic acid, isophthalic acid, terephthalic acid, and pyromellitic acid. Illustrative examples of the phenol compound or the naphthol compound include hydroquinone, resorcin, bisphenol A, bisphenol F, bisphenol S, phenolphthalin, methylated bisphenol A, methylated bisphenol F, methylated bisphenol S, phenol, o-cresol, m-cresol, p-cresol, catechol, α-naphthol, β-naphthol, 1,5-dihydroxy naphthalene, 1,6-dihydroxy naphthalene, 2,6-dihydroxy naphthalene, dihydroxy benzophenone, trihydroxy benzophenone, tetrahydroxy benzophenone, phloroglucin, benzene triol, a dicyclopentadiene type diphenol compound, and phenol novolac. Here, the "dicyclopentadiene type diphenol compound" means a diphenol compound obtained by condensation of one dicyclopentadiene molecule with two phenol molecules.

Specifically, preferable are the active ester type epoxy resin curing agent containing a dicyclopentadiene type diphenol structure, the active ester type epoxy resin curing agent containing a naphthalene structure, the active ester type epoxy resin curing agent containing an acetylated phenol novolac, and the active ester type epoxy resin curing agent containing a benzoylated phenol novolac. Here, the "dicyclopentadiene type diphenol structure" means a divalent structure formed of phenylene-dicyclopentylene-phenylene.

Illustrative examples of commercially available products of the active ester type epoxy resin curing agent include: as the active ester type epoxy resin curing agent containing a dicyclopentadiene type diphenol structure, "EXB9451", "EXB9460", "EXB9460S", "HPC-8000-65T", "HPC-8000H-65TM", and "EXB-8000L-65TM", which are all manufactured by DIC Corp.; as the active ester compound containing a naphthalene structure, "EXB9416-70BK", which is manufactured by DIC Corp.; as the active ester type epoxy resin curing agent containing an acetylated phenol novolac, "DC808" manufactured by Mitsubishi Chemical Corp.; as the active ester type epoxy resin curing agent containing a benzoylated phenol novolac, "YLH1026", "YLH1030", and "YLH1048", which are all manufactured by Mitsubishi Chemical Corp.; and as the active ester type epoxy resin curing agent that is the acetylated phenol novolac, "DC808" manufactured by Mitsubishi Chemical Corp.

The acid anhydride type epoxy resin curing agent may be the epoxy resin curing agent having one or more acid anhydride groups in one molecule thereof. Specifically, illustrative examples of the acid anhydride type epoxy resin curing agent include phthalic anhydride, tetrahydrophthalic anhydride, hexahydrophthalic anhydride, methyltetrahydrophthalic anhydride, methylhexahydrophthalic anhydride, methylnadic anhydride, hydrogenated methylnadic anhydride, trialkyltetrahydrophthalic anhydride, dodecenylsuccinic anhydride, 5-(2,5-dioxotetrahydro-3-furanyl)-3-methyl-3-cyclohexene-1,2-dicarboxylic anhydride, trimellitic anhydride, pyromellitic anhydride, benzophenone tetracarboxylic dianhydride, biphenyl tetracarboxylic dianhydride, naphthalene tetracarboxylic dianhydride, oxydiphthalic dianhydride, 3,3'-4,4'-diphenylsulfone tetracarboxylic dianhydride, 1,3,3a,4,5,9b-hexahydro-5-(tetrahydro-2,5-dioxo-3-furanyl)-naphtho[1,2-C]furan-1,3-dione, ethyleneglycol bis(anhydrotrimellitate), and a polymer type acid anhydride such as a styrene-maleic acid resin, which is a copolymer of styrene and maleic acid.

Illustrative examples of commercially available products of the acid anhydride type epoxy resin curing agent include: "HNA-100" and "MH-700", which are manufactured by New Japan Chemical Co., Ltd.

Specific examples of the benzoxazine type epoxy resin curing agent include "HFB2006M" manufactured by Showa Highpolymer Co., Ltd., and "P-d" and "F-a", which are manufactured by Shikoku Chemicals Corp.

Illustrative examples of the cyanate ester type curing agent include: bifunctional cyanate resins such as bisphenol A dicyanate, polyphenol cyanate, oligo(3-methylene-1,5-phenylenecyanate), 4,4'-methylenebis(2,6-dimethylphenylcyanate), 4,4'-ethylidene diphenyl dicyanate, hexafluorobisphenol A dicyanate, 2,2-bis(4-cyanate)phenylpropane, 1,1-bis(4-cyanatephenylmethane), bis(4-cyanate-3,5-dimethylphenyl)methane, 1,3-bis(4-cyanatephenyl-1-(methylethylidene))benzene, bis(4-cyanatephenyl)thioether, and bis(4-cyanatephenyl) ether; polyfunctional cyanate resins derived from a phenol novolac, a cresol novolac, and the like; and a prepolymer in which these cyanate resins are partially made to triazine. Specific examples of the cyanate ester type curing agent include "PT30" and "PT60" (both are phenol novolac type polyfunctional cyanate ester resins); and "BA230" and "BA230S75" (both are prepolymers in which part or all of bisphenol A dicyanate is made to triazine so as to be a trimer); all of these agents being manufactured by Arxada Japan Ltd.

Illustrative examples of the imidazole type epoxy resin curing agent include imidazole compounds and adducts of an imidazole compound with an epoxy compound, such as 2-methylimidazole, 2-undecylimidazole, 2-heptadecylimidazole, 1,2-dimethylimidazole, 2-ethyl-4-methylimidazole, 1,2-dimethylimidazole, 2-ethyl-4-methylimidazole, 2-phenylimidazole, 2-phenyl-4-methylimidazole, 1-bezyl-2-methylimidazole, 1-benzyl-2-phenylimidazole, 1-cyanoethyl-2-methylimidazole, 1-cyanoethyl-2-undecylimidazole, 1-cyanoethyl-2-ethyl-4-methylimidazole, 1-cyanoethyl-2-phenylimidazole, 1-cyanoethyl-2-undecylimidazolium trimellitate, 1-cyanoethyl-2-phenylimidazolium trimellitate, 2,4-diamino-6-[2'-methylimidazolyl-(1')]-ethyl-s-triazine, 2,4-diamino-6-[2'-undecylimidazolyl-(1')]-ethyl-s-triazine, 2,4-diamino-6-[2'-ethyl-4'-metylimidazolyl-(1')]-ethyl-s-triazine, a 2,4-diamino-6-[2'-methylimidazolyl-(1')]-ethyl-s-triazine isocyanuric acid adduct, a 2-phenylimidazole isocyanuric acid adduct, 2-phenyl-4,5-dihydroxymethylimidazole, 2-phenyl-4-methyl-5-hydroxymethylimidazole, 2,3-dihydro-1H-pyrro[1,2-a]benzimidazole, 1-dodecyl-2-methyl-3-benzylimidazolium chloride, 2-methylimidazoline, and 2-phenylimidazoline; and adducts of these imidazole compounds with an epoxy resin. Among these, 2-ethyl-4-methylimidazole and 1-benzyl-2-phenylimidazole are preferable.

Commercially available products may be used as the imidazole type epoxy resin curing agent. Illustrative examples thereof include "2MZA-PW" and "2PHZ-PW", which are manufactured by Shikoku Chemicals Corp., and "P200-H50" manufactured by Mitsubishi Chemical Corp.

The quantity ratio of the epoxy resin to the epoxy resin curing agent in terms of the ratio of [total number of the epoxy groups in the epoxy resins]: [total number of the reactive groups in the epoxy resin curing agents]is preferably in the range of 1:0.2 to 1:2, and more preferably in the range of 1:0.3 to 1:1.5, while still more preferably in the range of 1:0.4 to 1:1. Note that the reactive group of the epoxy resin curing agent means an active hydroxy group, an active ester group, and the like, and these are different depending on the epoxy resin curing agent. The total number of the epoxy groups in the epoxy resin means the total value of the values for all epoxy resins, obtained by dividing the mass of the non-volatile components in each epoxy resin by the epoxy equivalent. The total number of the reactive groups in the epoxy resin curing agent means the total value of the values for all epoxy resin curing agents, obtained by dividing the mass of the non-volatile components in each epoxy resin curing agent by the equivalent of the reactive group. When the quantity ratio of the epoxy resin to the epoxy resin curing agent is brought into this range, the heat resistance of the cured product obtained thereby is enhanced further.

The content of the epoxy resin curing agent relative to 100% by mass of the non-volatile components in the resin composition is preferably 0.1% by mass or more, more preferably 0.5% by mass or more, and still more preferably 0.8% by mass or more; and the upper limit thereof is preferably 8% by mass or less, more preferably 3% by mass or less, and still more preferably 2% by mass or less.

### Curing Accelerator

A curing accelerator usually acts as the catalyst of the curing reaction of the epoxy resin (B) so that the curing reaction may be accelerated. Illustrative examples of the curing accelerator include an amine type curing accelerator, an imidazole type curing accelerator, a phosphorous type curing accelerator, a guanidine type curing accelerator, and a metal type curing accelerator. From the viewpoint to lower the viscosity of the resin composition, the curing accelerator is preferably the amine type curing accelerator, the imidazole type curing accelerator, and the guanidine type curing accelerator; furthermore, from a viewpoint to enhance the mechanical strength of the cured product, the imidazole type curing accelerator is more preferable. The curing accelerator may be used singly, or as a combination of two or more of those described above. The curing accelerator is generally used in combination with the epoxy resin curing agent.

Illustrative examples of the amine type curing accelerator include: trialkylamines such as triethylamine and tributylamine; and 4-dimethylaminopyridine, benzyl dimethyl amine, 2,4,6-tris(dimethylaminomethyl)phenol, and 1,8-diazabicyclo(5,4,0)-undecene. Among these, 4-dimethylaminopyridine and 1,8-diazabicyclo(5,4,0)-undecene are preferable.

Commercially available products may be used as the amine type curing accelerator. Illustrative examples thereof include "PN-50", "PN-23", and "MY-25", which are all manufactured by Ajinomoto Fine-Techno Co., Inc.

The imidazole type curing accelerator is the same as the imidazole type epoxy resin curing agent described above. The imidazole type epoxy resin curing agent may function also as the curing accelerator when used in combination with other epoxy resin curing agent.

Illustrative examples of the phosphorous type curing agent include triphenyl phosphine, a phosphonium borate compound, tetraphenyl phosphonium tetraphenyl borate, n-butyl phosphonium tetraphenyl borate, a tetrabutyl phosphonium decanoate salt, (4-methylphenyl) triphenyl phosphonium thiocyanate, tetraphenyl phosphonium thiocyanate, and butyl triphenyl phosphonium thiocyanate. Among these, triphenyl phosphine and a tetrabutyl phosphonium decanoate salt are preferable.

Commercially available products may be used as the phosphorous type curing accelerator. Illustrative examples thereof include "TBP-DA" manufactured by HOKKO CHEMICAL INDUSTRY CO., LTD.

Illustrative examples of the guanidine type curing accelerator include dicyandiamide, 1-methyl guanidine, 1-ethyl guanidine, 1-cyclohexyl guanidine, 1-phenyl guanidine, 1-(o-tolyl) guanidine, dimethyl guanidine, diphenyl guanidine, trimethyl guanidine, tetramethyl guanidine, pentamethyl guanidine, 1,5,7-triazabicyclo[4.4.0]dec-5-ene, 7-methyl-1,5,7-triazabicyclo[4.4.0]dec-5-ene, 1-methyl biguanide, 1-ethyl biguanide, 1-n-butyl biguanide, 1-n-octadecyl biguanide, 1,1-dimethyl biguanide, 1,1-diethyl biguanide, 1-cyclohexyl biguanide, 1-allyl biguanide, 1-phenyl biguanide, and 1-(o-tolyl) biguanide. Among these, dicyandiamide and 1,5,7-triazabicyclo[4.4.0]dec-5-ene are preferable.

Illustrative examples of the metal type curing accelerator include organic metal complexes or organic metal salts of metals such as cobalt, copper, zinc, iron, nickel, manganese, and tin. Specific examples of the organometallic complex include organic cobalt complexes such as cobalt (II) acetylacetonate and cobalt (III) acetylacetonate; organic copper complexes such as copper (II) acetylacetonate; organic zinc complexes such as zinc (II) acetylacetonate; organic iron complexes such as iron (III) acetylacetonate; organic nickel complexes such as nickel (II) acetylacetonate; and organic manganese complexes such as manganese (II) acetylacetonate. Illustrative examples of the organic metal salt include zinc octylate, tin octylate, zinc naphthenate, cobalt naphthenate, tin stearate, and zinc stearate.

The content of the curing accelerator relative to 100% by mass of the non-volatile components in the resin composition is preferably 0.001% by mass or more, more preferably 0.005% by mass or more, and still more preferably 0.01% by mass or more; and the upper limit thereof is preferably 2% by mass or less, more preferably 0.1% by mass or less, and still more preferably 0.05% by mass or less.

The content of the curing agent (F) relative to 100% by mass of the non-volatile components in the resin composition is preferably 0.1% by mass or more, more preferably 0.5% by mass or more, and still more preferably 0.8% by mass or more; and the upper limit thereof is preferably 8% by mass or less, more preferably 4% by mass or less, and still more preferably 3% by mass or less.

### (G) Other Additives

The resin composition may include other additive (G) as an arbitrary non-volatile component. Illustrative examples of the other additive (G) include: a radically polymerizable compound; a polymerization initiator; an organometallic compound such as an organic copper compound, an organic zinc compound, and an organic cobalt compound; a coloring agent such as a phthalocyanine blue, a phthalocyanine green, an iodine green, a diazo yellow, a crystal violet, titanium oxide, and carbon black; polymerization inhibitors such as hydroquinone, catechol, pyrogallol, and phenothiazine; leveling agents such as a silicone type leveling agent and an acrylic polymer type leveling agent; thickeners such as bentone and montmorillonite; antifoaming agents such as a silicone type antifoaming agent, an acrylic type antifoaming agent, a fluorine type antifoaming agent, and a vinyl resin type antifoaming agent; UV absorbers such as a benzotriazole type UV absorber; adhesion enhancers such as a urea silane; adhesion assisting agents such as a triazole type adhesion assisting agent, a tetrazole type adhesion assisting agent, and a triazine type adhesion assisting agent; antioxidants such as a hindered phenol type antioxidant; fluorescent whitening agents such as a stilbene derivative; surfactants such as a fluorine type surfactant and a silicone type surfactant; flame retardants such as phosphorous-based flame retardants (e.g., a phosphate ester compound, a phosphazene compound, a phosphinate compound, and red phosphorus), nitrogen-based flame retardants (e.g., melamine sulfate), halogen-based flame retardants, and inorganic flame retardants (e.g., antimony trioxide); arbitrary dispersants (excluding those belonging to the component (C)) such as an phosphate ester type dispersant, a polyoxyalkylene type dispersant, an acetylene type dispersant, a silicone type dispersant, an anionic dispersant, and a cationic dispersant; stabilizers such as a borate-type stabilizer, a titanate type stabilizer, an aluminate type stabilizer, a zirconate type stabilizer, an isocyanate type stabilizer, a carboxylate type stabilizer, and a carboxylic acid anhydride type stabilizer; a photo polymerization assisting agent such as a tertiary amine; a photosensitizer such as a pyrazoline, an anthracene, a coumarin, a xanthone, and a thioxanthone. The other additive (G) may be used singly or as a combination of two or more of those described above.

### Physical Properties and the Like of Resin Composition

The cured product obtained by heating the resin composition at 190°C for 90 minutes exhibits the characteristic of excellent mechanical strength. Accordingly, the cured product may bring about the magnetic layer having excellent mechanical strength. The tensile strength thereof is preferably 70 MPa or more, more preferably 71 MPa or more, and still more preferably 72 MPa or more. Although the upper limit thereof is not particularly restricted, this may be made, for example, 150 MPa or less. The mechanical strength (tensile strength) may be measured by the method described in EXAMPLES to be described later.

The cured product obtained by heating the resin composition at 190°C for 90 minutes exhibits the characteristic of excellent mechanical strength. Accordingly, the cured product may bring about the magnetic layer having a high breaking elongation. The lower limit of the breaking elongation is preferably 0.5% or more, more preferably 0.55% or more, and still more preferably 0.6% or more. Although the upper limit thereof is not particularly restricted, this may be made, for example, 10% or less. The mechanical strength (breaking elongation) may be measured by the method described in EXAMPLES to be described later.

The cured product obtained by heating the resin composition at 190°C for 90 minutes exhibits the characteristic of excellent mechanical strength. Accordingly, the cured product may bring about the magnetic layer having an excellent Young's modulus. The lower limit of the Young's modulus is preferably 10 GPa or more, more preferably 11 GPa or more, and still more preferably 12 GPa or more. Although the upper limit thereof is not particularly restricted, this may be made, for example, 50 GPa or less. The mechanical strength (Young's modulus) may be measured by the method described in EXAMPLES to be described later.

The cured product obtained by heating the resin composition at 190°C for 90 minutes exhibits the characteristic of a high specific magnetic permeability at a frequency of 10 MHz. Accordingly, the cured product may bring about the magnetic layer having a high specific magnetic permeability. The specific magnetic permeability of this cured product at a frequency of 10 MHz is preferably 40 or more, more preferably 43 or more, and still more preferably 45 or more. Although the upper limit thereof is not particularly restricted, this may be made, for example, 100 or less. The specific magnetic permeability may be measured by the method described in EXAMPLES to be described later.

The cured product obtained by heating the resin composition at 190°C for 90 minutes usually exhibits the characteristic of a low loss factor at a frequency of 10 MHz. Accordingly, the cured product may bring about the magnetic layer having a low loss factor. The loss factor of the cured product at a frequency of 10 MHz is preferably 0.3 or less, more preferably 0.3 or less, and still more preferably 0.2 or less. Although the lower limit thereof is not particularly restricted, this may be made, for example, 0.001 or more. The loss factor may be measured by the method described in EXAMPLES to be described later.

From the viewpoint of utilizing the advantages described above, it is preferable to use the resin composition for forming the magnetic layer of a circuit board. From the viewpoint of utilizing the advantages described above, it is preferable to use the resin composition for filling the through hole in the core substrate.

### Resin Sheet

The resin sheet includes a support and a resin composition layer formed on the support, the resin composition layer being formed of the resin composition according to the present invention.

From the viewpoint of thinning, the thickness of the resin composition layer is preferably 5 µm or more, more preferably 10 µm or more, and especially preferably 50 µm or more, and preferably 600 µm or less, more preferably 300 µm or less, and especially preferably 200 µm or less.

Illustrative examples of the support include a film formed of a plastic material, metal foil, and a releasing paper. Among these, a film formed of a plastic material and of metal foil are preferable.

When the film formed of a plastic material is used as the support, illustrative examples of the plastic material include polyesters such as polyethylene terephthalate (hereinafter, sometimes this is simply called "PET") and polyethylene naphthalate (hereinafter, sometimes this is simply called "PEN"); polycarbonate (hereinafter, sometimes this is simply called "PC"); acrylic polymers such as polymethyl methacrylate (PMMA); a cyclic polyolefin; triacetyl cellulose (TAC); polyether sulfide (PES); polyether ketone; and polyimide. Among these, polyethylene terephthalate and polyethylene naphthalate are preferable, while inexpensive polyethylene terephthalate is especially preferable.

In the case that metal foil is used as the support, illustrative examples of the metal foil include copper foil and aluminum foil, and copper foil is preferable. As for the copper foil, the foil formed of a copper single metal or an alloy of copper with other metal (for example, tin, chromium, silver, magnesium, nickel, zirconium, silicon, and titanium) may be used.

The support may be mat-treated or corona-treated on the surface to be bonded with the resin composition layer.

As for the support, a releasing layer-attached support having a releasing layer on the surface to be bonded with the resin composition layer may be used. The releasing agent to be used in the releasing layer of the releasing layer-attached support may be one or more releasing agents selected from the group consisting of, for example, an alkyd resin, a polyolefin resin, a urethane resin, and a silicone resin. A commercially available product may also be used as the releasing layer-attached support. Illustrative examples thereof include a PET film having a releasing layer mainly formed of an alkyd resin type releasing agent, such as "PET501010", "SK-1", "AL-5", and "AL-7", which are all manufactured by Lintech Corp.; "Lumirror T60" manufactured by Toray Industries, Inc.; "Purex" manufactured by Teijin Ltd.; and "Unipeel" manufactured by Unitika Ltd.

Although the thickness of the support is not particularly restricted, it is preferably in the range of 5 µm to 75 µm, and more preferably in the range of 10 µm to 60 µm. When the releasing layer-attached support is used, total thickness of the releasing layer-attached support is preferably within this range.

The resin sheet may be produced, for example, by forming the resin composition layer on the support by applying the resin composition on the support by means of a die coater or the like. As needed, the resin composition is dissolved into a solvent to prepare a resin varnish; and then, this resin varnish may be applied onto the support. When the solvent is used, as needed, drying may be carried out after the application.

Drying may be carried out by heating, blowing with a hot air, or the like. The drying condition is not particularly restricted. The drying is carried out under the drying condition so as to bring the content of the organic solvent in the resin composition layer to usually 10% or less by mass, and preferably 5% or less by mass. The resin composition layer may be formed by drying at 50°C to 150°C for 3 minutes to 10 minutes, although the condition is different depending on the components included in the resin composition.

In the resin sheet, a protection film similar to the support may be further laminated on the surface of the resin composition layer not bonded to the support (namely, on the surface opposite to the support). Although thickness of the protection film is not particularly restricted, for example, this is in the range of 1 µm to 40 µm. By laminating the protection film, the resin composition layer may be prevented from attachment of dirt and the like as well as from a scar on the surface thereof. The resin sheet can be rolled up so as to be stored. When the resin sheet has the protection film, the resin sheet can be used by removing the protection film.

### Circuit Board and Production Method Thereof

The circuit board according to one embodiment of the present invention includes the magnetic layer. This magnetic layer contains the cured product of the resin composition described above, or the cured product of the resin composition layer of the resin sheet; and it is preferable that the magnetic layer contains only the cured product of the resin composition described above. A specific structure of the circuit board is not restricted as long as the magnetic layer containing the cured product of the resin composition described above is provided. A circuit board according to a first embodiment is a circuit board having a core substrate as the substrate formed with a through hole and a magnetic layer filled in this through hole. A circuit board according to a second embodiment is a circuit board including a magnetic layer formed of the cured product of the resin composition layer in the resin sheet. In these circuit boards, the magnetic layer may be the cured product of the resin composition layer, and may be the cured product of the resin composition. Hereinafter, the first embodiment and the second embodiment with regard to the circuit board producing method will be explained. Note that the circuit board producing method relating to the present invention is not limited to the first embodiment and the second embodiment exemplified below.

### First Embodiment

The circuit board according to the first embodiment has the core substrate formed with the through hole and the magnetic layer filled in this through hole. This circuit board producing method includes, for example, the following steps in this order:
(1) laminating a core substrate formed with a through hole and a resin sheet such that the resin composition layer is filled in the through hole, and
(2) curing the resin composition layer to form a magnetic layer.

The circuit board producing method according to the first embodiment may also include an arbitrary step in combination with the above steps (1) through (2). For example, the circuit board producing method may include the steps of
(3) polishing the magnetic layer,
(4) applying a roughening treatment to the magnetic layer, and
(5) forming a conductive layer on the magnetic layer. Usually, the step (3), the step (4), and the step (5) are performed in this order.

### Step (1)

The step (1) usually includes the step to prepare the core substrate formed with the through hole. The core substrate may be prepared by purchase from the market. Alternatively, the core substrate may be prepared by production using a suitable material. Hereinafter, the production method of the core substrate according to one example will be described.

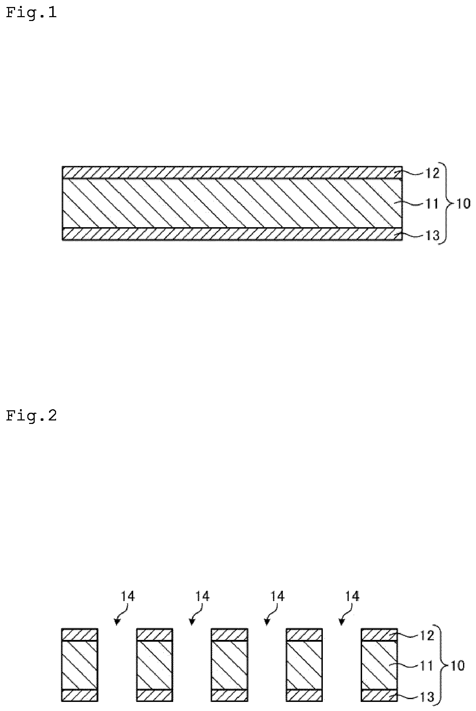

Fig. 1 is a schematic sectional view illustrating a core substrate 10 before forming a through hole in the circuit board producing method according to the first embodiment of the present invention. A step of preparing the core substrate 10 may include preparing the core substrate 10 not formed with the through hole to be filled with the magnetic layer, as illustrated in Fig. 1. This core substrate 10 is the substrate before forming the through hole; here, this may be a plate-like member.

The core substrate 10 usually includes a supporting substrate 11. Illustrative examples of the supporting substrate 11 include insulating substrates such as a glass epoxy substrate, a metal substrate, a polyester substrate, a polyimide substrate, a BT resin substrate, and a thermosetting type polyphenylene ether substrate. On the supporting substrate 11, a metal layer may be formed. The metal layer may be formed on one surface of the supporting substrate 11, or on both the surfaces thereof. Here, the example is illustrated in which a metal layer 12 and a metal layer 13 are formed on both the surfaces of the supporting substrate 11. The metal layers 12 and 13 may be the layers formed by a metal such as copper. The metal layers 12 and 13 may be, for example, copper foil such as carrier-attached copper foil, or a metal layer formed of the material of the conductive layer that is going to be described later.

Fig. 2 is a schematic sectional view illustrating the core substrate 10 formed with a through hole 14 in the circuit board producing method according to the first embodiment of the present invention. As illustrated in Fig. 2, the step of preparing the core substrate 10 may include forming the through hole 14 in the core substrate 10. The through hole 14 may be formed, for example, by drilling, laser irradiation, or plasma irradiation. The through hole 14 may usually be formed by forming a penetrating hole through the core substrate 10. Specifically, formation of the through hole 14 may be carried out by using a drilling machine that is commercially available. Illustrative examples of the commercially available drilling machine include "ND-1S211" manufactured by Hitachi Via Mechanics, Ltd.

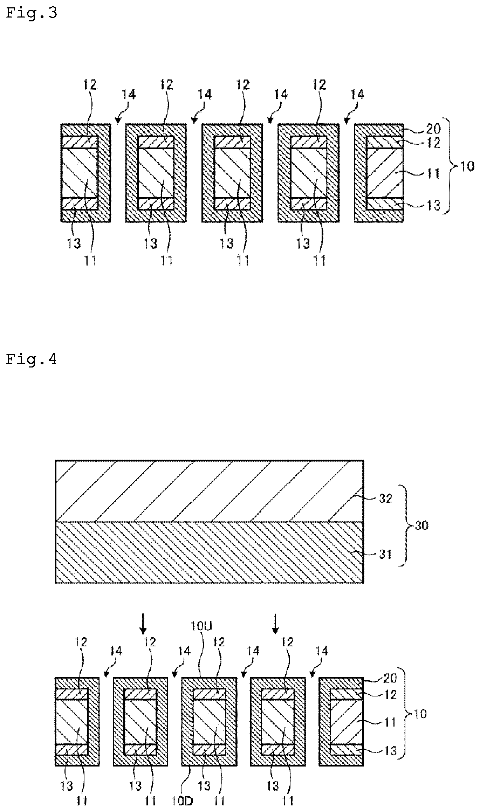

Fig. 3 is a schematic sectional view illustrating the core substrate 10 formed with a plated layer 20 in the through hole 14 in the circuit board producing method according to the first embodiment of the present invention. After the core substrate 10 is roughened as needed, the step of preparing the core substrate 10 may include forming the plated layer 20, as illustrated in Fig. 3. As the roughening treatment, any of a dry roughening treatment and a wet roughening treatment may be carried out. Illustrative examples of the dry roughening treatment include a plasma treatment. Illustrative examples of the wet roughening treatment include a method in which a swelling treatment by a swelling liquid, a roughening treatment by an oxidant, and a neutralizing treatment by a neutralizing solution are carried out in this order. The plated layer 20 may be formed by a plating method. The procedure to form the plated layer 20 by the plating method may be the same as that in formation of the conductive layer at step (5) that is going be described later. Here, the explanation will be made as to the example in which the plated layer 20 is formed inside the through hole 14, on the surface of the metal layer 12, and on the surface of the metal layer 13. In this example, the core substrate formed with the plated layer 20 is described with the same code "10" as the core substrate 10 before forming the plated layer 20.

Fig. 4 is a schematic sectional view illustrating the state of the lamination of the core substrate 10 with a resin sheet 30 in the circuit board producing method according to the first embodiment of the present invention. As illustrated in Fig. 4, the step (1) includes, after the core substrate 10 formed with the through hole 14 is prepared, laminating the core substrate 10 with the resin sheet 30. In this embodiment, the example of laminating the resin sheet 30 having a resin composition layer 31 and a support 32 on one surface 10U of the core substrate 10 is illustrated. In the following description, the surface 10U of the core substrate 10 that is bonded to the resin sheet 30 is sometimes referred to as "first surface 10U" and the opposite surface as "second surface 10D".

Lamination of the core substrate 10 with the resin sheet 30 is performed such that part or whole of the resin composition layer 31 is filled in the through hole 14. Therefore, lamination is usually performed so that the resin composition layer 31 and the core substrate 10 is bonded. Specifically, the aforementioned lamination may be performed by bonding the resin composition layer 31 to the core substrate 10 by hot-pressing the resin sheet 30 to the core substrate 10. When the resin sheet 30 has the support 32, as in the example illustrated in Fig. 4, the aforementioned lamination may be done by pressing the resin sheet 30 from the side of the support 32 onto the core substrate 10. Illustrative examples of the member used for hot-pressing (hereinafter, this is sometimes referred to as "hot-pressing member", not illustrated in the drawing) include a heated metal plate (such as a SUS mirror plate) and a metal roll (SUS roll). Here, the hot-pressing member may be pressed directly to the resin sheet 30, but it is preferable that the pressing is made via an elastic material such as a heat-resistant rubber in such a way that the resin sheet 30 may well follow the surface irregularity of the core substrate 10.

Lamination of the core substrate 10 with the resin sheet 30 may be conducted, for example, by a vacuum lamination method. Lamination conditions may be, for example, as follows. The hot-pressing temperature is preferably in the range of 60°C to 160°C, and more preferably in the range of 80°C to 140°C. The pressure of the hot-pressing is preferably in the range of 0.098 MPa to 1.77 MPa, and more preferably 0.29 MPa to 1.47 MPa. The period of the hot-pressing is preferably in the range of 20 seconds to 400 seconds, and more preferably in the range of 30 seconds to 300 seconds. The lamination is carried out under a reduced pressure, preferably 13 hPa or less.

After the lamination, the laminated resin sheet 30 may be flattened by pressing the hot-pressing member from the side of the support 32 under a normal pressure (under an atmospheric pressure). The pressing conditions of the flattening process may be the same as the hot-pressing conditions in the before-mentioned lamination. Note that the lamination and the flattening processes may be carried out continuously by using a commercially available vacuum laminator.

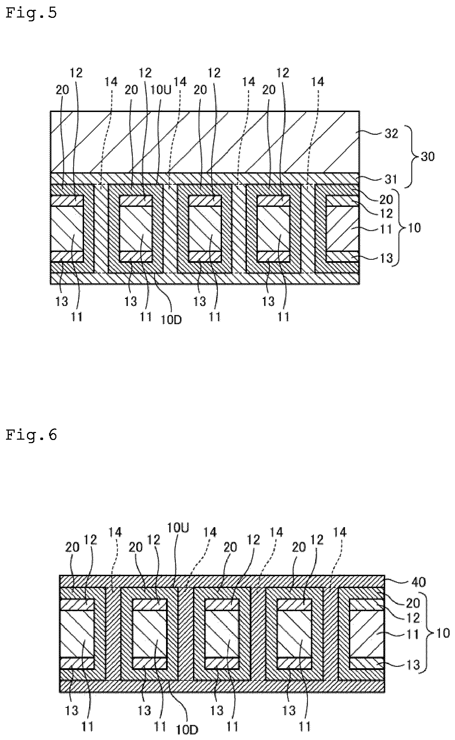

Fig. 5 is a schematic sectional view illustrating the state of the lamination of the core substrate 10 with the resin sheet 30 in the circuit board producing method according to the first embodiment of the present invention. The lamination of the core substrate 10 with the resin sheet 30 causes the resin composition layer 31 of the resin sheet 30 to enter into the through hole 14, as illustrated in Fig. 5, so that the through hole 14 is filled with the resin composition layer 31. Here, the example will be described in which a part of the resin composition layer 31 enters into the through hole 14, and another part does not enter into the through hole 14, thereby adhering to the first surface 10U of the core substrate 10. Thus, the resin composition layer 31 may be formed on the first surface 10U of the core substrate 10. In addition, yet another portion of the resin composition layer 31 that has entered the through hole 14 may pass through the through hole 14 and be dispensed from an opening on the side of the second surface 10D of the core substrate 10. Therefore, the resin composition layer 31 may be formed on the second surface 10D of the core substrate 10.

Usually, the support 32 is removed after the lamination of the core substrate 10 with the resin sheet 30. In this embodiment, an example of removing the support 32 after lamination of the core substrate 10 with the resin sheet 30 and before the step (2) is illustrated and explained. However, removal of the support 32 may be performed after the step (2).

### Step (2)

Fig. 6 is a schematic sectional view to explain the step (2) in the circuit board producing method according to the first embodiment of the present invention. The step (2) includes curing the resin composition layer 31 after laminating the core substrate 10 with the resin sheet 30, as illustrated in Fig. 6. By curing the resin composition layer 31, a magnetic layer 40 containing the cured product of the resin composition may be formed. The magnetic layer 40 may be formed in the through hole 14 and also usually on the first surface 10U and the second surface 10D of the core substrate 10.

Curing of the resin composition layer 31 is usually carried out by thermal curing. Conditions of the thermal curing of the resin composition layer 31 may be set as appropriate so far as the resin composition layer 31 may be cured. The curing temperature is preferably 60°C or higher, more preferably 70°C or higher, and still more preferably 80°C or higher, and preferably 245°C or lower, more preferably 220°C or lower, and still more preferably 200°C or lower. The curing period is preferably 5 minutes or longer, more preferably 10 minutes or longer, and still more preferably 15 minutes or longer, and preferably 120 minutes or shorter, more preferably 110 minutes or shorter, and still more preferably 100 minutes or shorter.

The curing degree of the magnetic layer 40 that is obtained at the step (2) is preferably 80% or more, more preferably 85% or more, and still more preferably 90% or more. The curing degree may be measured by using, for example, a differential scanning calorimeter.

The production method of the circuit board may include, after the core substrate 10 is laminated with the resin sheet 30 and before the resin composition layer 31 is cured, the step at which the resin composition layer 31 is heated at the temperature lower than the curing temperature thereof (preliminary heating step). For example, before curing the resin composition layer 31, the resin composition layer 31 may be preliminarily heated usually at 50°C or higher and lower than 120°C (preferably 60°C or higher and 110°C or lower, more preferably 70°C or higher and 100°C or lower) for the period of usually 5 minutes or longer (preferably 5 minutes to 150 minutes, more preferably 15 minutes to 120 minutes).

### Step (3)

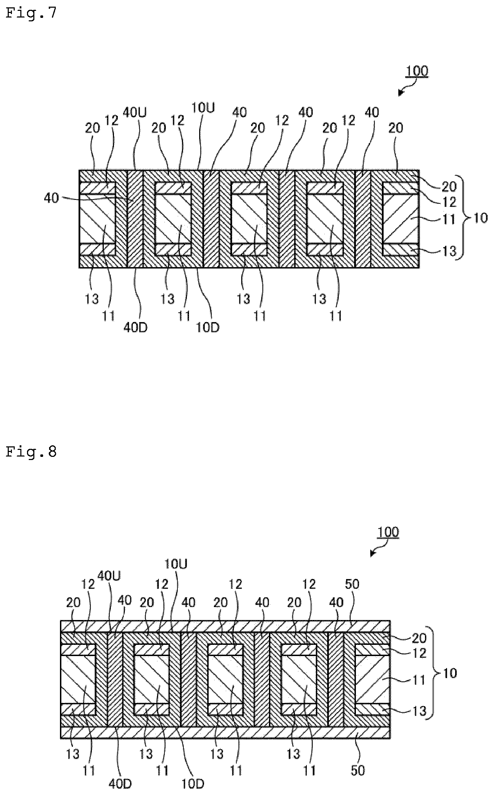

Fig. 7 is a schematic sectional view to explain the step (3) in the circuit board producing method according to the first embodiment of the present invention. The step (3) may include polishing the magnetic layer 40. Specifically, the step (3) may include polishing the magnetic layer 40 in the area outside the through hole 14. In the example illustrated in this embodiment, the magnetic layer 40 is formed on the first surface 10U and the second surface 10D of the core substrate 10, so that the magnetic layer 40 in the portions on those first surface 10U and the second surface 10D may be polished. The portion of the magnetic layer 40 outside of the through hole 14 is generally a surplus portion that is not needed in the final product. The aforementioned polishing can remove the surplus portion, as illustrated in Fig. 7. The polishing can also flatten the polished surfaces 40U and 40D as the surfaces of the magnetic layer 40.

As for the polishing method, a method that can remove unnecessary portions of the magnetic layer 40 may be employed. Illustrative examples of such a polishing method include a buff polishing method, a belt polishing method, and a ceramic polishing method. Illustrative examples of the buff polishing equipment that is commercially available include "NT-700IM" manufactured by Ishiihyoki Co., Ltd.

From a viewpoint to enhance the adhesion with the conductive layer (not illustrated in Fig. 7), the arithmetic average roughness (Ra) of the polished surfaces 40U and 40D of the magnetic layer 40 is preferably 300 nm or more, more preferably 350 nm or more, and still more preferably 400 nm or more. The upper limit thereof is preferably 1000 nm or less, more preferably 900 nm or less, and still more preferably 800 nm or less. The surface roughness (Ra) may be measured by using, for example, a non-contact type surface roughness meter.

After the step (2) and before the step (3), the magnetic layer 40 may be heat-treated to further increase the curing degree of the magnetic layer 40. As for the temperature at this heat treatment, the above-mentioned curing temperature may be applied. Specifically, the temperature at the heat treatment is preferably 120°C or higher, more preferably 130°C or higher, and still more preferably 150°C or higher, and preferably 245°C or lower, more preferably 220°C or lower, and still more preferably 200°C or lower. The heat-treatment period is preferably 5 minutes or longer, more preferably 10 minutes or longer, still more preferably 15 minutes or longer, and preferably 150 minutes or shorter, more preferably 120 minutes or shorter, and still more preferably 100 minutes or shorter.

By performing the steps (1) and (2) described above and further performing the step (3) as needed, a circuit board 100 having the core substrate 10 and the magnetic layer 40 filled in the through holes 14 of the core substrate 10 may be obtained. The circuit board 100 thus obtained may be subjected to step (4) and step (5) to form a conductive layer, as needed.

### Step (4)

The step (4) includes the step at which the magnetic layer is roughened. Usually, a roughening treatment is applied to the polished surface of the magnetic layer. At the step (4), not only the polished surface of the magnetic layer but also the surfaces 10U and 10D of the core substrate 10 may be subjected to the roughening treatment.

The procedure and condition of the roughening treatment are not particularly restricted; for example, the procedure and condition that are used in the production method of a multilayer printed wiring board may be used. Specifically, the roughening treatment may be carried out by the method including a swelling treatment with a swelling liquid, a roughening treatment with an oxidant, and a neutralization treatment with a neutralizing solution in this order.

Illustrative examples of the swelling liquid that may be used in the swelling treatment include an alkaline solution and a surfactant solution; here, an alkaline solution is preferable. As for the alkaline solution as the swelling liquid, a sodium hydroxide solution and a potassium hydroxide solution are more preferable. Illustrative examples of the swelling liquid that is commercially available include "Swelling Dip Securiganth P" and "Swelling Dip Securiganth SBU", which are both manufactured by Atotech Japan Co., Ltd.

The swelling treatment with the swelling liquid may be carried out, for example, by soaking the magnetic layer into the swelling liquid at 30°C to 90°C for the period of 1 minute to 20 minutes. From the viewpoint of suppressing swelling of the resin in the magnetic layer to a suitable level, it is preferable that the magnetic layer is soaked into the swelling liquid at 40°C to 80°C for the period of 5 minutes to 15 minutes.

As for the oxidant that can be used in the roughening treatment, illustrative examples thereof include an alkaline permanganate solution having potassium permanganate or sodium permanganate dissolved into a sodium hydroxide aqueous solution. The roughening treatment using the oxidant such as the alkaline permanganate solution is carried out preferably by soaking the magnetic layer into the oxidant heated to 60°C to 80°C for the period of 10 minutes to 30 minutes. Concentration of the permanganate salt in the alkaline permanganate solution is preferably in the range of 5% by mass to 10% by mass. Illustrative examples of the oxidant that is commercially available include alkaline permanganate solutions such as "Concentrate Compact P" and "Dosing Solution Securiganth P", which are both manufactured by Atotech Japan, Co., Ltd.

The neutralizing solution that may be used in the neutralization treatment is preferably an acidic aqueous solution. Illustrative examples of commercially available product of the neutralizing solution include "Reduction Solution Securiganth P", which is manufactured by Atotech Japan Co., Ltd. The neutralization treatment with the neutralizing solution may be carried out by soaking the surface, which has been treated with the roughening treatment using the oxidant solution, into the neutralizing solution at 30°C to 80°C for the period of 5 minutes to 30 minutes. From the viewpoint of workability and the like, it is preferable to soak the magnetic layer, which has been treated with the roughening process using the oxidant solution, into the neutralizing solution at 40°C to 70°C for the period of 5 minutes to 20 minutes.

From the viewpoint to enhance the adhesion with the conductive layer, the arithmetic average roughness (Ra) of the surface of the magnetic layer after the roughening treatment is preferably 300 nm or more, more preferably 350 nm or more, and still more preferably 400 nm or more. The upper limit thereof is preferably 1500 nm or less, more preferably 1200 nm or less, and still more preferably 1000 nm or less. The surface roughness (Ra) may be measured by using, for example, a non-contact type surface roughness meter.

### Step (5)

Fig. 8 is a schematic sectional view to explain the step (5) in the producing method of the circuit board 100 according to the first embodiment of the present invention. The step (5) includes forming a conductive layer 50 on the polished surfaces 40U and 40D of the magnetic layer 40, as illustrated in Fig. 8. In this embodiment, the example is illustrated in which the conductive layer 50 is formed not only on the polished surfaces 40U and 40D of the magnetic layer 40 but also on the surface therearound (for example, the first surface 10U and the second surface 10D of the core substrate 10). In Fig. 8, the example that the conductive layer 50 is formed on both sides of the core substrate 10 is illustrated; but the conductive layer 50 may be formed on one side of the core substrate 10.

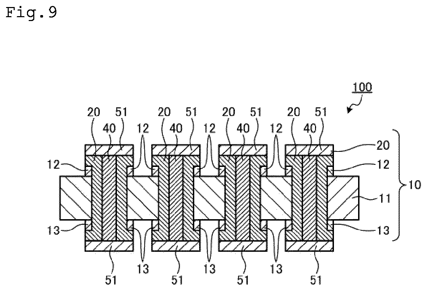

Fig. 9 is a schematic sectional view to explain the step (5) in the production method of the circuit board 100 according to the first embodiment of the present invention. The step (5) may include after the conductive layer 50 is formed, removing parts of the conductive layer 50, the metal layers 12 and 13, and the plated layer 20 by etching or the like to form a patterned conductive layer 51, as illustrated in Fig. 9.

Illustrative examples of the method for forming the conductive layer 50 include a plating method, a sputtering method, and a vapor deposition method. Among these, the plating method is preferable. In a preferable embodiment, the surface of the magnetic layer 40 (and the core substrate 10, as needed) is plated with a suitable method such as a semi-additive method or a full additive method, so that the patterned conductive layer 51 having an intended wiring pattern may be formed. Illustrative examples of the material of the conductive layer 50 include: single metals such as gold, platinum, palladium, silver, copper, aluminum, cobalt, chromium, zinc, nickel, titanium, tungsten, iron, tin, and indium; and alloys of two or more metals selected from the group consisting of gold, platinum, palladium, silver, copper, aluminum, cobalt, chromium, zinc, nickel, titanium, tungsten, iron, tin, and indium. Among these, from viewpoints of general applicability, cost, easiness in patterning, and the like, preferably usable are chromium, nickel, titanium, aluminum, zinc, gold, palladium, silver, and copper, as well as a nickel-chromium alloy, a copper-nickel alloy, and a copper-titanium alloy. More preferable are chromium, nickel, titanium, aluminum, zinc, gold, palladium, silver, and copper, as well as a nickel-chromium alloy. Copper is still more preferably used.

Here, the example of the method to form the patterned conductive layer 51 will be explained in detail. A plated seed layer is formed on the polished surfaces 40U and 40D of the magnetic layer 40 by electroless plating. Next, after a mask pattern is formed as needed onto the plated seed layer thus formed, an electroplated layer is formed by electroplating. Then, as needed, the mask pattern is removed, and then further an unnecessary plated seed layer is removed by etching or the like, so that the patterned conductive layer 51 having an intended wiring pattern can be formed. After the patterned conductive layer 51 is formed, in order to enhance the adhesion strength of the patterned conductive layer 51, an annealing treatment may be carried out, as needed. The annealing treatment may be carried out, for example, by heating at 150°C to 200°C for the period of 20 minutes to 90 minutes.

The thickness of the patterned conductive layer 51 is preferably 1 µm or more, more preferably 3 µm or more, and still more preferably 5 µm or more, and preferably 70 µm or less, more preferably 50 µm or less, still more preferably 40 µm or less, and especially preferably 10 µm or less.

By the method described above, the circuit board 100 having the magnetic layer 40 will be obtained. The magnetic layer 40 is obtained by curing the resin composition layer 31; thus, this includes the cured product of the resin composition. Therefore, the magnetic layer 40 will contain more magnetic powder (not illustrated in the drawing) so that this can have excellent magnetic properties.

### Second Embodiment

A circuit board according to a second embodiment includes a magnetic layer that is formed by the cured product of the resin composition layer in the resin sheet. The circuit board producing method includes, for example,
(A) a step of laminating a resin sheet to an inner layer substrate such that a resin composition layer is bonded to the inner layer substrate to form a magnetic layer.

The circuit board producing method according to the second embodiment may include an arbitrary step in addition to the step (A). For example, the circuit board producing method may include:
(B) a step of drilling the magnetic layer,
(C) a step of applying a roughening treatment to the magnetic layer, and
(D) a step of forming a conductive layer on the magnetic layer. This producing method preferably includes steps (A) through (D) in this order.

### Step (A)

The step (A) is a step of laminating a resin sheet to an inner layer substrate such that a resin composition layer is bonded to the inner layer substrate to form a magnetic layer. In one embodiment of the step (A), the resin sheet is laminated to the inner layer substrate such that the resin composition layer is bonded to the inner layer substrate, and then, the resin composition layer is thermally cured to form the magnetic layer.

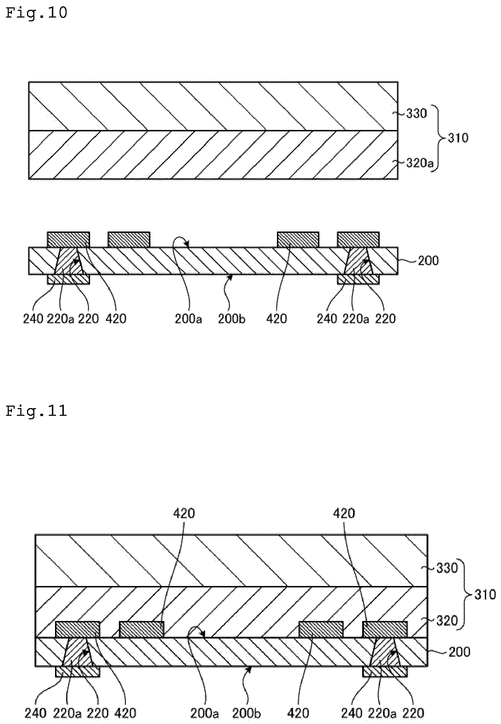

Fig. 10 is a schematic sectional view to explain the step (A) in the circuit board producing method according to the second embodiment of the present invention. At the step (A), a resin sheet 310 having a support 330 and a resin composition layer 320a formed on the support 330 is laminated to an inner layer substrate 200 such that the resin composition layer 320a is bonded to the inner layer substrate 200.

The inner layer substrate 200 is an insulating substrate. Illustrative examples of the material of the inner layer substrate 200 include insulating substrates such as a glass epoxy substrate, a metal substrate, a polyester substrate, a polyimide substrate, a BT resin substrate, and a thermosetting type polyphenylene ether substrate. The inner layer substrate 200 may be an inner layer circuit substrate having a wiring or the like incorporated in the thickness thereof.

As illustrated in Fig. 10 as one example, the inner layer substrate 200 has a first conductive layer 420 formed on a first main surface 200a and an outside terminal 240 formed on a second main surface 200b. The first conductive layer 420 may include a plurality of wires. In the example illustrated by the drawing, only a wire that forms a coil-like conductive structural body 400 of an inductor element is illustrated. The outside terminal 240 is a terminal to electrically connect to an outside device or the like that is not illustrated in the drawing. The outside terminal 240 may be constructed as part of the conductive layer formed on the second main surface 200b.

Conductive materials that are capable of forming the first conductive layer 420 and the outside terminal 240 are the same as the materials of the conductive layer that have been explained in the section of "Step (5)" in the first embodiment.

The first conductive layer 420 and the outside terminal 240 may be any of a monolayer structure and a multilayer structure in which two or more layers formed of single metal layers or alloy layers formed of different metals are laminated. Thicknesses of the first conductive layer 420 and of the outside terminal 240 are the same as those of a second conductive layer 440 to be described later.

The line (L)/space (S) ratios of the first conductive layer 420 and of the outside terminal 240 are not particularly restricted. From the viewpoint of reducing irregularity of the surface to obtain the magnetic layer that is excellent in the smoothness, the ratio is usually 900/900 µm or less, preferably 700/700 µm or less, more preferably 500/500 µm or less, still more preferably 300/300 µm or less, and far still more preferably 200/200 µm or less. The lower limit of the line/space ratio is not particularly restricted; from the viewpoint of enhancing an embedding property of the resin composition layer into the space, the ratio is preferably 1/1 µm or more.

The inner layer substrate 200 may have a plurality of through holes 220 that are formed so as to penetrate through the inner layer substrate 200 from the first main surface 200a to the second main surface 200b. In the through hole 220, an inside-the-through-hole wiring 220a is formed. The inside-the-through-hole wiring 220a electrically connects the first conductive layer 420 with the outside terminal 240.

Bonding of the resin composition layer 320a to the inner layer substrate 200 is the same as in the method of laminating the core substrate and the resin sheet described in the section of "Step (1)" in the first embodiment.

After the resin sheet is laminated to the inner layer substrate, the resin composition layer is thermally cured to form a magnetic layer. As illustrated in Fig. 11 as one example, the resin composition layer 320a that is bonded to the inner layer substrate 200 is thermally cured to form a first magnetic layer 320.

The thermal curing conditions of the resin composition layer 320a are the same as the thermal curing conditions of the resin composition layer described in the section of "Step (2)" in the first embodiment.

The support 330 may be removed between the time after thermal curing at the step (A) and step (B), or after the step (B).

### Step (B)

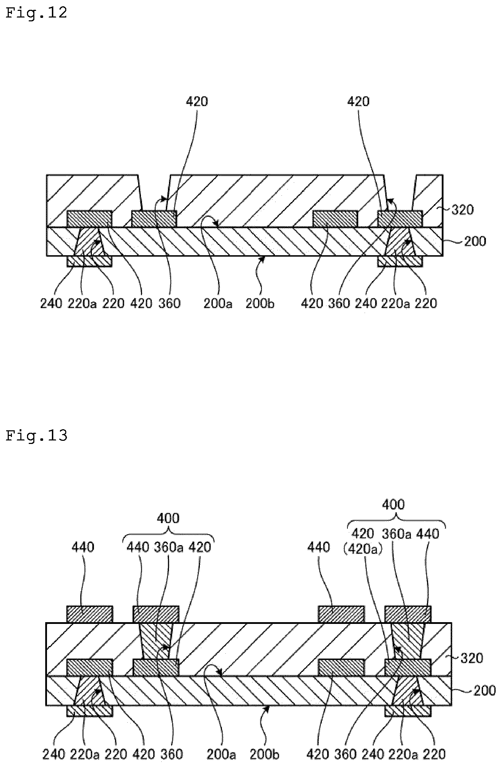

Fig. 12 is a schematic sectional view to explain the step (B) in the circuit board producing method according to the second embodiment of the present invention. At the step (B), a via hole 360 is formed by carrying out the hole-making process in the first magnetic layer 320.

The via hole 360 will be a channel to electrically connect the first conductive layer 420 with the second conductive layer 440 to be described later. Formation of the via hole 360 may be carried out by using a drill, laser, plasma, or the like in accordance with a composition and the like of the resin composition used to form the magnetic layer. The size and shape of the via hole may be determined as appropriate in accordance with a design of the circuit board.

### Step (C)

Step (C) includes roughening the magnetic layer having formed the via hole. The roughening method at the step (C) is the same as in the method that has been explained in the section of "Step (4)" in the first embodiment.

The roughening treatment at the step (C) may also be a polishing treatment of the surface of the insulating layer. The polishing method is the same as in the method that has been explained in the section of "Step (3) " in the first embodiment.

From the viewpoint of enhancing the plating adhesion, the arithmetic average roughness (Ra) of the magnetic layer after the roughening treatment is preferably 300 nm or more, more preferably 350 nm or more, and still more preferably 400 nm or more. The upper limit thereof is preferably 1000 nm or less, more preferably 900 nm or less, and still more preferably 800 nm or less. The surface roughness (Ra) may be measured by using, for example, a non-contact type surface roughness meter.

### Step (D)

Fig. 13 is a schematic sectional view to explain step (D) in the circuit board producing method according to the second embodiment of the present invention. The step (D), as illustrated in Fig. 13 as one example, includes forming the second conductive layer 440 on the first magnetic layer 320.

The conductive materials that are capable of forming the second conductive layer 440 are the same as those of the conductive layer explained in the section of "Step (5)" in the first embodiment.

From the viewpoint of thinning, the thickness of the second conductive layer 440 is preferably 70 µm or less, more preferably 60 µm or less, still more preferably 50 µm or less, far still more preferably 40 µm or less, and especially preferably 30 µm or less, 20 µm or less, 15 µm or less, or 10 µm or less. The lower limit thereof is preferably 1 µm or more, more preferably 3 µm or more, and still more preferably 5 µm or more.

The second conductive layer 440 may be formed by plating. For example, the second conductive layer 440 is preferably formed by a wet plating method such as a semi-additive method including an electroless plating process, a mask patterning process, an electroplating process, and a flash etching process, as well as a full additive method. When the second conductive layer 440 is formed by the wet plating method, the second conductive layer 440 having an intended wiring pattern will be formed. Note that, at this process, an inside-the-via-hole wiring 360a is concurrently formed in the via hole 360.

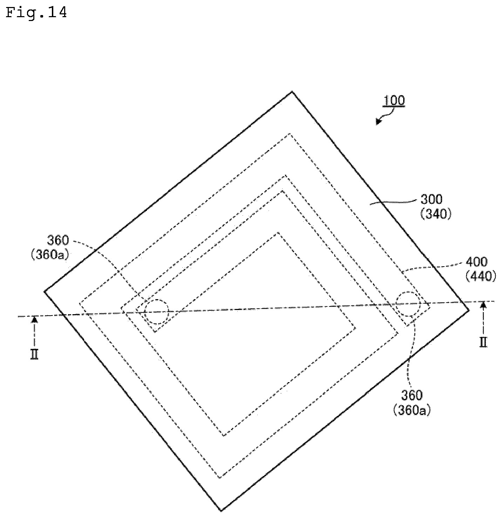

The first conductive layer 420 and the second conductive layer 440 may be formed, for example, spirally, as illustrated in Fig. 14 to Fig. 16 to be described later as one example. In one example, one end on the center side of the spiral wiring part of the second conductive layer 440 is electrically connected through the inside-the-via-hole wiring 360a to one end on the center side of the spiral wiring part of the first conductive layer 420. The other end on the outer circumferential side of the spiral wiring part of the second conductive layer 440 is electrically connected through the inside-the-via-hole wiring 360a to a land 420a of the first conductive layer 42. Therefore, the other end on the outer circumferential side of the spiral wiring part of the second conductive layer 440 is electrically connected to the outside terminal 240 through the inside-the-via-hole wiring 360a, the land 420a, and the inside-the-through-hole wiring 220a.

The coil-like conductive structural body 400 is composed of the spiral wiring part that is part of the first conductive layer 420, the spiral wiring part that is part of the second conductive layer 440, and the inside-the-via-hole wiring 360a that electrically connects between the spiral wiring part of the first conductive layer 420 and the spiral wiring part of the second conductive layer 440.

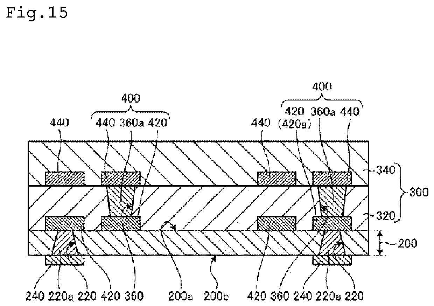

After the step (D), a step of further forming a magnetic layer on the conductive layer may be carried out. Specifically, as illustrated in Fig. 15 as one example, a second magnetic layer 340 is formed on the first magnetic layer 320 that has the second conductive layer 440 and the inside-the-via-hole wiring 360a formed therein. The second magnetic layer may be formed with the same step as the step that has already been explained.

### Inductor Board

The inductor board includes the circuit board of the present invention. When the inductor component includes the circuit board obtained by the circuit board producing method according to the first embodiment, this has an inductor pattern that is formed by a conductor at least in part around the cured product of the resin composition layer. As such an inductor board, the one described in, for example, Japanese Patent Application Laid-open No. 2016-197624 is applicable.

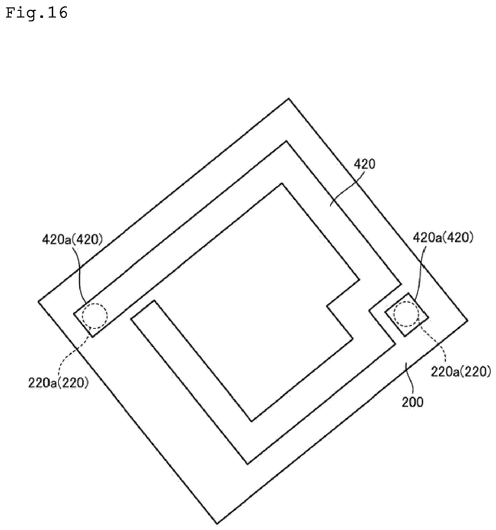

When the inductor board includes the circuit board obtained by the circuit board producing method according to the second embodiment, the inductor board has a magnetic layer and a conductive structural body having at least part thereof been embedded into the magnetic layer. The inductor board includes this conductive structural body and an inductor element that is extendedly present in a thickness direction of the magnetic layer and is composed of part of the magnetic layer surrounded by the conductive structural body. Note that, Fig. 14 is a schematic plan view observed from one side along the thickness direction of the inductor board, which includes the inductor element therein. Fig. 15 is a schematic plan view illustrating a cut end face of the inductor board that is cut at the place indicated by the II-II one dot chain line illustrated in Fig. 14. Fig. 16 is a schematic plan view to explain a composition of the first conductive layer in the inductor board.

As illustrated in Fig. 14 and Fig. 15 as one example, a circuit board 100 has a plurality of magnetic layers (the first magnetic layer 320 and the second magnetic layer 340) and a plurality of conductive layers (the first conductive layer 420 and the second conductive layer 440). Namely, this is a build-up wiring board having a build-up magnetic layer and a build-up conductive layer. Also, the circuit board 100 has an inner layer substrate 200.

From Fig. 15, the first magnetic layer 320 and the second magnetic layer 340 constitute a magnetic portion 300, which may be regarded as an integrated magnetic layer of these magnetic layers. Therefore, the coil-like conductive structural body 400 is formed in such a way that at least part thereof may be embedded into the magnetic member 300. Namely, in the inductor board 100 according to this embodiment, the inductor element is composed of the coil-like conductive structural body 400 and a core part, which is extendedly present in the thickness direction of the magnetic portion 300 and is part of the magnetic member 300 that is surrounded by the coil-like conductive structural body 400.

As illustrated in Fig. 16 as one example, the first conductive layer 420 includes the spiral wiring part to constitute the coil-like conductive structural body 400 and the land 420a in a square shape that is electrically connected to the inside-the-through-hole wiring 220a. In the example illustrated by the drawing, the spiral wiring includes a linear portion, a bent portion that is bent at a right angle to the linear portion, and a detour portion that detours the land 420a. In the example illustrated by the drawing, the entire outline of the spiral wiring part of the first conductive layer 420 is almost in a square shape and has a shape that is whirled in the counterclockwise direction from a center side to an outer side.

Similarly, the second conductive layer 440 is formed on the first magnetic layer 320. The second conductive layer 440 includes the spiral wiring part to constitute the coil-like conductive structural body 400. In Fig. 14 or Fig. 15, the spiral wiring part includes a linear portion and a bent portion that is bent at right angle to the linear portion. In Fig. 14 or Fig. 15, the entire of the outline of spiral wiring part of the second conductive layer 440 is almost in a square shape and the wiring part has a shape that is wound in the clockwise direction from a center side to an outer side.

The inductor board can be used as the wiring board to mount an electronic part such as a semiconductor chip, and may also be used as a (multi-layered) printed wiring board that uses this wiring board as the inner layer substrate. In addition, this may be used as a chip inductor board obtained by dicing the wiring board, and may also be used as a printed wiring board that is surface-mounted with the chip inductor board.

In addition, by using this wiring board, semiconductor devices with various embodiments may be produced. The semiconductor device having the wiring board may be suitably used in electric products (for example, a computer, a mobile phone, a digital camera, and a television), vehicles (for example, a motor bike, an automobile, a train, a marine ship, and an airplane), and so forth.

### EXAMPLES

Hereinafter, the present invention will be specifically described by Examples, but the present invention is not limited to these Examples. Note that "part" and "%" with regard to the quantity means "part by mass" and "% by mass", respectively, unless otherwise specifically mentioned.

### Synthesis Example 1: Synthesis of Polyester Solution 1

In a reaction flask equipped with a thermometer, a stirrer, a nitrogen inlet, and a reflux tube, 10.0 parts of 12-hydroxystearic acid (manufactured by Junsei Chemical Co., Ltd.) and 190 parts of ε-caprolactone (manufactured by Junsei Chemical Co., Ltd.) were added. The temperature thereof was raised to 160°C for 4 hours under a stream of nitrogen, and after heating at 160°C for 2 hours, the heating was carried out until the remaining ε-caprolactone content reached 1% or less. The reaction mixture was then cooled to room temperature. Hereafter, this reaction solution is referred to as polyester solution 1.

### Synthesis Example 2: Synthesis of Amine Type Dispersant 1

In a reaction flask equipped with a thermometer, a stirrer, a nitrogen inlet, and a reflux tube, a mixture consisting of 25.0 parts of xylene and 70 parts of a 10% aqueous solution of polyallylamine ("PAA-1LV": manufactured by Nitto Boseki Co., Ltd., number-average molecular weight of about 3,000) was stirred at 160°C with distilling out the water and returning the xylene to the reaction solution by using a separator while adding to the resultant, 14.21 parts of the polyester solution 1 obtained in Synthesis Example 1 and previously heated up to 160°C. The reaction was carried out at 160°C for 2 hours. The heating was further carried out at 160°C for 4 hours, which was then followed by removal of xylene by distillation to obtain an amine type dispersant 1. The amine type dispersant 1 has a polyester skeleton in which R in the general formula (1) is an alkylene group having 5 carbon atoms, and was characterized by the amine value of 20.0 mg KOH/g and the acid value of 16.0 mg KOH/g. The pH in the indicator method was 6.

### Synthesis Example 3: Synthesis of Amine Dispersant 2

In a reaction flask equipped with a thermometer, a stirrer, a nitrogen inlet, and a reflux tube, a mixture consisting of 25.0 parts of xylene and 70 parts of a 10% aqueous solution of polyallylamine ("PAA-1LV": manufactured by Nitto Boseki Co., Ltd., number-average molecular weight of about 3,000) was stirred at 160°C with distilling out the water and returning the xylene to the reaction solution by using a separator while adding to the resultant, 14.21 parts of the polyester solution 1 obtained in Synthesis Example 1 and previously heated up to 160°C. The reaction was carried out at 160°C for 3 hours. The heating was further carried out at 160°C for 4 hours, which was then followed by removal of xylene by distillation to obtain an amine type dispersant 2. Amine dispersant 2 has a polyester skeleton in which R in the general formula (1) is an alkylene group having 5 carbon atoms, and was characterized by an amine value of 11.0 mg KOH/g and an acid value of 17.5 mg KOH/g. The pH in the indicator method was 6.

### Example 1

0.21 parts of a resin oligomer having a weight-average molecular weight of 600 or more and less than 8000 ("jER1001": manufactured by Mitsubishi Chemical Corp., bisphenol A type epoxy resin, epoxy equivalent weight (EPW) of 475 g/eq., softening temperature of 64°C, bifunctional (2B), weight-average molecular weight of 900), 0.65 parts of an epoxy resin ("ZX-1059": manufactured by Nippon Steel Chemical & Material Co., Ltd., mixture of bisphenol A type epoxy resin and bisphenol F type epoxy resin), 0.18 parts of the amine type dispersant 1, 1.00 part of cyclohexanone, 1.00 part of methyl ethyl ketone, 34.90 parts of magnetic powder ("KUAMET-NC1·53 µm": manufactured by Epson Atmix Corp., nanocrystals of Fe-Si-Nb-B alloy, average particle diameter (D₅₀) of 27.3 µm), 4.32 parts of magnetic powder ("AW2-08PF3F": manufactured by Epson Atmix Corp., Fe-Si-Cr alloy powder, amorphous powder, average particle diameter (D₅₀) of 3.1 µm), 4.31 parts of magnetic powder "CVD Iron Powder (0.7 µm)": manufactured by JFE Mineral & Alloy Co., LTD., average particle diameter (D₅₀) of 0.7 µm), and 0.84 parts of a phenol resin ("LA-7054": manufactured by DIC Corp., 60%-solid content in methyl ethyl ketone solution, hydroxyl group equivalent of about 125) were mixed and uniformly dispersed using a high-speed rotary mixer to prepare a resin composition.

### Example 2

In Example 1,
1) 0.21 parts of the resin oligomer having a weight-average molecular weight of 600 or more and less than 8000 ("jER1001": manufactured by Mitsubishi Chemical Corp., bisphenol A type epoxy resin, epoxy equivalent weight (EPW) of 475 g/eq., softening temperature of 64°C, bifunctional (2B), weight-average molecular weight of 900) was replaced by 0.21 parts of a resin oligomer having a weight-average molecular weight of 600 or more and less than 8000 ("jER4005P": manufactured by Mitsubishi Chemical Corp., bisphenol F type epoxy resin, weight-average molecular weight of 6200), and
2) 0.18 parts of the amine type dispersant 1 was replaced by 0.18 parts of the amine type dispersant 2.

A resin composition was produced in the same way as in Example 1 except for the above items.

### Example 3

In Example 1,
- 0.21 parts of the resin oligomer having a weight-average molecular weight of 600 or more and less than 8000 ("jER1001": manufactured by Mitsubishi Chemical Corp., bisphenol A type epoxy resin, epoxy equivalent weight (EPW) of 475 g/eq., softening temperature of 64°C, bifunctional (2B), weight-average molecular weight of 900) was replaced by 0.21 parts of the resin oligomer having a weight-average molecular weight of 600 or more and less than 8000 ("jER4005P": manufactured by Mitsubishi Chemical Corp., bisphenol F type epoxy resin, weight-average molecular weight of 6200).

A resin composition was produced in the same way as in Example 1 except for the above item.

### Example 4

In Example 1,
1) 0.21 parts of the resin oligomer having a weight-average molecular weight of 600 or more and less than 8000 ("jER1001": manufactured by Mitsubishi Chemical Corp., bisphenol A type epoxy resin, epoxy equivalent weight (EPW) 475 g/eq., softening temperature of 64°C, bifunctional (2B), weight-average molecular weight of 900) was replaced by 0.23 parts of the resin oligomer having a weight-average molecular weight of 600 or more and less than 8000 ("jER4005P": manufactured by Mitsubishi Chemical Corp., bisphenol F type epoxy resin, weight-average molecular weight of 6200),
2) the amount of the epoxy resin ("ZX-1059": manufactured by Nippon Steel Chemical & Material Co., Ltd., mixture of bisphenol A type epoxy resin and bisphenol F type epoxy resin) was changed from 0.65 parts to 0.74 parts,
3) 0.18 parts of the amine type dispersant 1 was changed to 0.09 parts of the amine type dispersant 2,
4) the amount of methyl ethyl ketone was changed from 1.00 part to 1.30 parts, and
5) 0.84 parts of the phenol resin ("LA-7054": manufactured by DIC Corp., in methyl ethyl ketone solution with 60% solid content, hydroxyl group equivalent of about 125) was replaced by 0.48 parts of a phenol resin ("TD-2090": manufactured by DIC Corp., hydroxyl group equivalent of 105 g/eq., softening temperature of 120°C).

A resin composition was prepared in the same way as in Example 1 except for the above items.

### Example 5

In Example 4,
1) the amount of the amine type dispersant 2 was changed from 0.09 parts to 0.08 parts, and
2) 0.01 parts of a curing accelerator ("TBP-DA" manufactured by Hokko Chemical Industry Co., Ltd.) was used.

A resin composition was prepared in the same way as in Example 4 except for the above items.

### Example 6

In Example 1,
1) 0.21 parts of the resin oligomer having a weight-average molecular weight of 600 or more and less than 8000 ("jER1001": manufactured by Mitsubishi Chemical Corp., bisphenol A type epoxy resin, epoxy equivalent weight (EPW) of 475 g/eq., softening temperature of 64°C, bifunctional (2B), weight-average molecular weight of 900) was replaced by 0.9 parts of a resin having a weight-average molecular weight of 8000 or more ("YX7553H30": manufactured by Mitsubishi Chemical Corp., phenoxy resin having a special skeleton, 30% solution in methyl ethyl ketone:cyclohexanone=1:1, weight-average molecular weight of 35000),
2) the amount of the epoxy resin ("ZX-1059"; manufactured by Nippon Steel Chemical & Material Co., Ltd., mixture of bisphenol A type epoxy resin and bisphenol F type epoxy resin) was changed from 0.65 parts to 0.56 parts,
3) the amount of the amine type dispersant 1 was changed from 0.18 parts to 0.27 parts,
4) the amount of methyl ethyl ketone was changed from 1.00 part to 0.05 parts,
5) the amount of the phenol resin ("LA-7054": manufactured by DIC Corp., in methyl ethyl ketone solution with 60% solid content, hydroxyl group equivalent of about 125) was changed from 0.84 parts to 0.73 parts, and
6) 0.01 parts of the curing accelerator ("TBP-DA": manufactured by Hokko Chemical Industry Co., Ltd.) was used.

A resin composition was prepared in the same way as in Example 1 except for the above items.

### Example 7

In Example 1,
1) 0.18 parts of the amine type dispersant 1 was replaced by 0.18 parts of an amine type dispersant ("Solsperse 24000GR", manufactured by Lubrizol Japan, (amine value of 40 mg KOH/g, acid value of 25 mg KOH/g, polyester)).

A resin composition was prepared in the same way as in Example 1 except for the above items.

### Comparative Example 1

In Example 6,
0.27 parts of the amine type dispersant 2 was replaced by 0.27 parts of a dispersant ("SC-1015F": manufactured by NOF Corp., polyoxyalkylene type dispersant).

A resin composition was prepared in the same way as in Example 6 except for the above items.

### Comparative Example 2

In Example 6,
0.27 parts of the amine type dispersant 2 was replaced by 0.27 parts of a dispersant ("KBM-103"; manufactured by manufactured by Shin-Etsu Chemical Co., Ltd., phenylsilane coupling agent).

A resin composition was prepared in the same way as in Example 6 except for the above items.

### Comparative Example 3

In Example 6,
0.27 parts of the amine type dispersant 2 was replaced by 0.27 parts of a dispersant ("KBM-573": manufactured by Shin-Etsu Chemical Co., Ltd., amino silane type coupling agent).

A resin composition was prepared in the same way as in Example 6 except for the above items.

### Measurements of Specific Magnetic Permeability and of Loss Factor

### (1) Preparation of Cured Product

A polyethylene terephthalate (PET) film ("PET 501010"; thickness of 50 µm; manufactured by Lintec Corp.) that was treated with a silicone type releasing treatment was prepared as the support. Each resin composition was uniformly applied onto the releasing surface of the PET film by using a doctor blade such that the thickness of the resin composition layer after drying might become 100 µm to obtain a resin sheet. The resin sheet thereby obtained was heated at 190°C for 90 minutes to thermally cure the resin composition layer; then, the support was peeled off to obtain a cured product in a sheet form. Hereafter, this cured product in a sheet form is sometimes referred to as sample A.

### (2) Measurement of Specific Magnetic Permeability and of Loss Factor

The sample A thus obtained was cut to obtain an evaluation sample having an outer diameter of 19.2 mm and an inner diameter of 8.2 mm in the form of donut. The specific magnetic permeability (µ'), the imaginary component of complex magnetic permeability (µ"), and the loss factor (tanδ) of the evaluation sample were measured using a magnetic material test fixture "16454A" manufactured by Keysight Technologies, Inc. and an impedance analyzer "E4991B" manufactured by Keysight Technologies, Inc. at a measurement frequency of 10 MHz and room temperature of 23°C. The loss factor tanδ was calculated from the formula [tanδ = µ"/µ']. The relative permeability was evaluated in accordance with the following standard.
O: The specific magnetic permeability is 40 or more.
X: The specific magnetic permeability is less than 40.

### Evaluation of Tensile Strength of Cured Product of Resin Composition

The sample A was used to evaluate the tensile strength. Measurement of the tensile strength was carried out using a tensile tester "RTC-1250A" manufactured by Orientec Co., Ltd. to determine the breaking point strength at 23°C. The measurement was carried out in accordance with JIS K7127. In addition, the tensile strength was evaluated based on the following standard.
O: Tensile strength of 70 MPa or more.
X: Tensile strength is less than 70 MPa.

### Evaluation of Elongation

Elongation was evaluated using the sample A. Measurement of the tensile strength was carried out using a tensile tester "RTC-1250A" manufactured by Orientec Co., Ltd. to determine the breaking elongation at 23°C. The measurement was carried out in accordance with JIS K6251.

### Measurement of Young's Modulus

The Young's modulus was evaluated using the sample A. Measurement of the tensile strength was carried out using a tensile tester "RTC-1250A" manufactured by Orientec Co., Ltd., to determine the Young's modulus at 23°C. The measurement was carried out in accordance with JIS K6253.

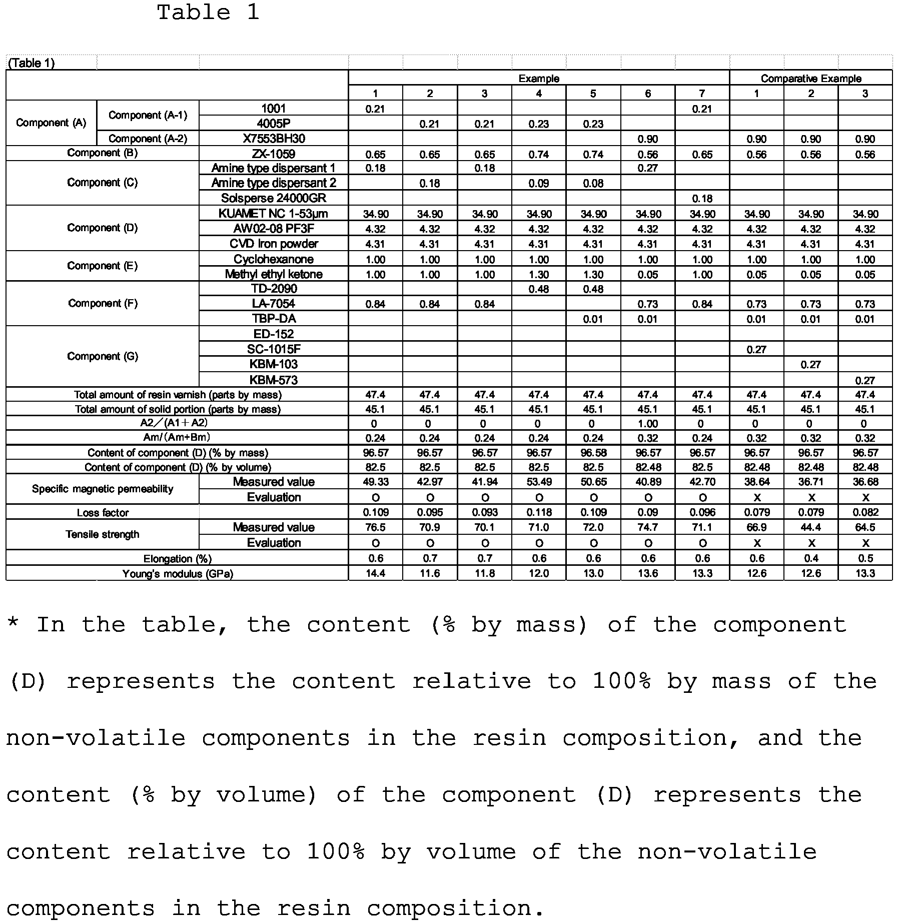

## Claims

1. A resin composition comprising:
(A) a resin having a weight-average molecular weight of 600 or more, wherein the weight-average molecular weight is the weight molecular weight in terms of polystyrene measured with a gel permeation chromatography method;
(B) **an** epoxy resin excluding those falling under the component (A);
(C) **an** amine type dispersant; **and**
(D) a magnetic powder.

2. The resin composition according to claim 1, wherein the component (A) comprises (A-1) a resin oligomer having a weight-average molecular weight of 600 or more **and** less than 8000.

3. A resin composition according to claim 1 or 2, wherein the component (A) comprises any one of (A-1) a resin oligomer having a weight-average molecular weight of 600 or more and less than 8000 and (A-2) a resin having a weight-average molecular weight of 8000 or more.

4. The resin composition according to claim 3, wherein A2/(A1 + A2) is 0 or more and 0.7 or less, provided that A1 represents a content of the component (A-1) and A2 represents a content of the component (A-2), relative to 100% by mass of non-volatile components in the resin composition.

5. The resin composition according to any one of claims 2 to 4, wherein the component (A-1) comprises an epoxy group-containing oligomer.

6. The resin composition according to any one of claims 1 **to 5,** wherein Am/(Am + Bm) is 0.1 or more and 0.8 or less, provided that Am represents a content of the component (A) and Bm represents a content of the component (B), relative to 100% by mass of non-volatile components in the resin composition.

7. The resin composition according to any one of claims 1 to 6, wherein the component (C) comprises a polyester skeleton.

8. The resin composition according to any one of claims 1 to 7, wherein the component (C) comprises a polyester skeleton represented by formula (1): 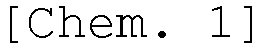 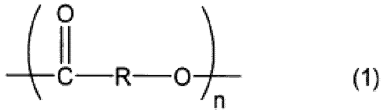 (in general formula (1), each R independently represents a divalent hydrocarbon group having 2 to 10 carbon atoms, and n represents an integer of 2 to 1000).

9. The resin composition according to any one of claims 1 to 8, wherein a content (% by volume) of the component (D) relative to 100% by volume of non-volatile components in the resin composition is 70% by volume or more.

10. The resin composition according to any one of claims 1 to 9, wherein the resin composition further comprises (E) a solvent.

11. A resin sheet comprising:
a support; and
a resin composition layer that is formed on the support and is formed by using the resin composition according to any one of claims 1 to 10.

12. A circuit board comprising:
a substrate having a through hole; and
a cured product of the resin composition according to any one of claims 1 to 10 filled in the through hole.

13. A circuit board comprising a magnetic layer that is a cured product of the resin composition according to any one of claims 1 to 10.

14. An inductor board comprising the circuit board according to claim 12.

15. An inductor board comprising the circuit board according to claim 13.

## Patentansprüche

1. Harzzusammensetzung, die Folgendes umfasst:
(A) ein Harz mit einem gewichtsmittleren Molekulargewicht von 600 oder mehr, wobei das gewichtsmittlere Molekulargewicht das durch ein Gelpermeationschromatographie-Verfahren gemessene Molekulargewicht, ausgedrückt als Polystyrol, ist;
(B) ein Epoxidharz, ausgenommen die unter Komponente (A) fallenden;
(C) ein Dispergiermittel vom Amin-Typ; und
(D) ein magnetisches Pulver.

2. Harzzusammensetzung nach Anspruch 1, wobei Komponente (A) (A-1) ein Harz-Oligomer mit einem gewichtsmittleren Molekulargewicht von 600 oder mehr und weniger als 8.000 umfasst.

3. Harzzusammensetzung nach Anspruch 1 oder 2, wobei Komponente (A) ein beliebiges aus (A-1) einem Harz-Oligomer mit einem gewichtsmittleren Molekulargewicht von 600 oder mehr und weniger als 8.000 und (A-2) einem Harz mit einem gewichtsmittleren Molekulargewicht von 8.000 oder mehr umfasst.

4. Harzzusammensetzung nach Anspruch 3, wobei gilt: A2/(A1+A2) = 0 oder mehr und 0,7 oder weniger, mit der Maßgabe, dass A1 für den Gehalt der Komponente (A-1) steht und A2 für den Gehalt der Komponente (A-2) steht, bezogen auf 100 Massen-% nichtflüchtiger Komponenten in der Harzzusammensetzung.

5. Harzzusammensetzung nach einem der Ansprüche 2 bis 4, wobei Komponente (A-1) ein Epoxygruppen enthaltendes Oligomer umfasst.

6. Harzzusammensetzung nach einem der Ansprüche 1 bis 5, wobei gilt:
Am/(Am+Bm) = 0,1 oder mehr und 0,8 oder weniger, mit der Maßgabe, dass Am für den Gehalt der Komponente (A) steht und Bm für den Gehalt der Komponente (B) steht, bezogen auf 100 Massen-% nichtflüchtiger Bestandteile in der Harzzusammensetzung.

7. Harzzusammensetzung nach einem der Ansprüche 1 bis 6, wobei Komponente (C) ein Polyester-Skelett umfasst.

8. Harzzusammensetzung nach einem der Ansprüche 1 bis 7, wobei Komponente (C) ein Polyester-Skelett umfasst, das durch die Formel (1) dargestellt ist: 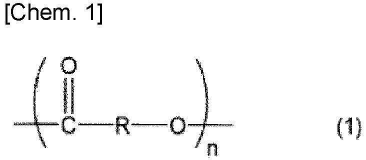 (wobei in der allgemeinen Formel (1) die R jeweils unabhängig für eine zweiwertige Kohlenwasserstoffgruppe mit 2 bis 10 Kohlenstoffatomen steht und n für eine ganze Zahl von 2 bis 1.000 steht).

9. Harzzusammensetzung nach einem der Ansprüche 1 bis 8, wobei der Gehalt (Vol.-%) von Komponente (D), bezogen auf 100 Vol.-% der nichtflüchtigen Bestandteile in der Harzzusammensetzung, 70 Vol.-% oder mehr beträgt.

10. Harzzusammensetzung nach einem der Ansprüche 1 bis 9, wobei die Harzzusammensetzung weiters (E) ein Lösungsmittel umfasst.

11. Harzplatte, die Folgendes umfasst:
einen Träger; und
eine Harzzusammensetzungs-Schicht, die auf dem Träger ausgebildet ist und unter Verwendung einer Harzzusammensetzung nach einem der Ansprüche 1 bis 10 ausgebildet ist.

12. Leiterplatte, die Folgendes umfasst:
ein Substrat mit einem Durchgangsloch; und
ein gehärtetes Produkt aus einer Harzzusammensetzung nach einem der Ansprüche 1 bis 10, die in das Durchgangsloch eingefüllt ist.

13. Leiterplatte, die eine magnetische Schicht umfasst, die ein gehärtetes Produkt aus einer Harzzusammensetzung nach einem der Ansprüche 1 bis 10 ist.

14. Induktorplatte, die eine Leiterplatte nach Anspruch 12 umfasst.

15. Induktorplatte, die eine Leiterplatte nach Anspruch 13 umfasst.

## Revendications

1. Composition de résines, comprenant :
(A) une résine présentant un poids moléculaire moyen en poids de 600 ou plus, dans laquelle le poids moléculaire moyen en poids est le poids moléculaire en poids en termes de polystyrène mesuré à l'aide d'un procédé de chromatographie par perméation de gel ;
(B) une résine époxy à l'exclusion de celles relevant du composant (A) ;
(C) un dispersant de type amine ; et
(D) une poudre magnétique ;

2. Composition de résines selon la revendication 1, dans laquelle le composant (A) comprend (A-1) un oligomère de résine présentant un poids moléculaire moyen en poids de 600 ou plus et inférieur à 8 000.

3. Composition de résines selon la revendication 1 ou 2, dans laquelle le composant (A) comprend un quelconque parmi (A-1) un oligomère de résine présentant un poids moléculaire moyen en poids de 600 ou plus et inférieur à 8 000 et (A-2) une résine présentant un poids moléculaire moyen en poids de 8 000 ou plus.

4. Composition de résines selon la revendication 3, dans laquelle A2 / (A1 + A2) est supérieur ou égal à 0 et inférieur ou égal à 0,7, à condition que A1 représente une teneur du composant (A-1) et A2 représente une teneur du composant (A-2), par rapport à 100 % en masse de composants non volatils dans la composition de résines.

5. Composition de résines selon l'une quelconque des revendications 2 à 4, dans laquelle le composant (A-1) comprend un oligomère contenant un groupe époxy.

6. Composition de résines selon l'une quelconque des revendications 1 à 5, dans laquelle Am / (Am + Bm) est supérieur ou égal à 0,1 et inférieur ou égal à 0,8, à condition que Am représente une teneur du composant (A) et Bm représente une teneur du composant (B), par rapport à 100 % en masse de composants non volatils dans la composition de résines.

7. Composition de résines selon l'une quelconque des revendications 1 à 6, dans laquelle le composant (C) comprend un squelette de polyester.

8. Composition de résine selon l'une quelconque des revendications 1 à 7, dans laquelle le composant (C) comprend un squelette de polyester représenté par la formule (1) : 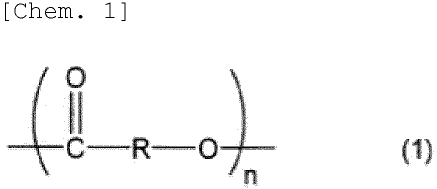 (dans la formule générale (1), chaque R représente indépendamment un groupe hydrocarboné divalent présentant de 2 à 10 atomes de carbone, et n représente un entier de 2 à 1 000).

9. Composition de résines selon l'une quelconque des revendications 1 à 8, dans laquelle une teneur (% en volume) du composant (D) par rapport à 100 % en volume de composants non volatils dans la composition de résine est de 70 % en volume ou plus.

10. Composition de résines selon l'une quelconque des revendications 1 à **9,** dans laquelle la composition de résines comprend en outre (E) un solvant.

11. Feuille de résine, comprenant :
un support ; et
une couche de composition de résines qui est formée sur le support et est formée en utilisant la composition de résines selon l'une quelconque des revendications 1 à 10.

12. Carte de circuit imprimé, comprenant :
un substrat présentant un trou traversant ; et
un produit durci de la composition de résine selon l'une quelconque des revendications 1 à 10 versée dans le trou traversant.

13. Carte de circuit comprenant une couche magnétique qui est un produit durci de la composition de résines selon l'une quelconque des revendications 1 à 10.

14. Carte d'inducteur comprenant la carte de circuit selon la revendication 12.

15. Carte **d'inducteur** comprenant la carte de circuit selon la revendication 13.
